# EUROPEAN PATENT APPLICATION

(11) **EP 4 701 388 A1**
(43) Date of publication of application: **25.02.2026**
(21) Application number: 25193957.5
(22) Date of filing: 05.08.2025
(51) Int. Cl.: H10K 59/80

(54) **DISPLAY DEVICE AND ELECTRONIC DEVICE INCLUDING THE SAME**

(30) Priority: 21.08.2024 KR 20240111828
(71) Applicant: Samsung Display Co., Ltd., Yongin-si, Gyeonggi-do 17113 (KR)
(72) Inventor: CHA, Gwangmin, 17113 Giheung-gu, Yongin-si, Gyeonggi-do (KR); KIM, Jungi, 17113 Giheung-Gu, Yongin-si, Gyeonggi-Do (KR); RYU, Younjoo, 17113 Giheung-Gu, Yongin-si, Gyeonggi-Do (KR); YUN, Sanghyun, 17113 Giheung-Gu, Yongin-si, Gyeonggi-Do (KR); LEE, Jaehun, 17113 Giheung-Gu, Yongin-si, Gyeonggi-Do (KR); JUNG, Hyunyoung, 17113 Giheung-Gu, Yongin-si, Gyeonggi-Do (KR)
(74) Representative: Dr. Weitzel & Partner

(57) **Abstract**

A display device (DD) includes a display element layer (DP-ED) including a pixel-defining film (PDL) and a light-emitting element (ED-1, ED-2, ED-3), and a light control layer (RCL) disposed on the display element layer (DP-ED). The light control layer (RCL) includes an organic film (TMA) in which a first region (T-OH1) and a second region (T-OH2) spaced apart from each other in one direction perpendicular to a thickness direction of the display device are defined, a light blocking part (BMA) disposed in the first region (T-OH1), and an optical pattern (LRP) disposed in the second region (T-OH2). A first width (W1) of the organic film (TMA) progressively decreases away from the display element layer (DP--ED) along the thickness direction, a second width (W2) of the light blocking part (BMA) progressively increases away from the display element layer (DP-ED) along the thickness direction, and the first width and the second width are in the one direction.

## Description

The present invention relates to a display device including a light control layer, especially a light control layer which controls light having an exit angle equal to or greater than a predetermined angle. Further, the present invention relates to an electronic device including a display device, and a method of manufacturing the display device.

With the advancement of the information society, the demands for display devices capable of displaying images are becoming increasingly diverse. Display devices are now integrated into various electronic devices, including smartphones, digital cameras, laptops, car navigation systems, and smart televisions. Additionally, display devices are utilized in automotive applications, such as instrument panels, center fascias, and center information displays (CIDs) located on car dashboards.

Such a display device may include a configuration for limiting an exit angle of light, which may improve security or a reflection phenomenon.

Embodiments of the present inventive concept provide a display device with excellent display quality and a method of manufacturing the same.

According to an embodiment of the inventive concept, a display device includes a display element layer including a pixel-defining film and a light-emitting element, and a light control layer disposed on the display element layer in a thickness direction of the display device. The light control layer includes an organic film in which a first region and a second region at least partially spaced apart from each other in one direction perpendicular to the thickness direction are defined, a light blocking part disposed in the first region, and an optical pattern disposed in the second region. A first width of the organic film between the light blocking part and the optical pattern in the one direction progressively decreases away from the display element layer along the thickness direction, a second width of the light blocking part in the one direction progressively increases away from the display element layer along the thickness direction. At least partially spaced from another means that it is not excluded that the first region and the second region are in contact with each other in a specific plane, for example in the plane up to which the organic film reaches, especially if the remaining organic film has a tip in a cross-sectional view parallel to the thickness direction, as explained below.

As the first region and the second region are regions which have been removed from the organic film, for example by etching like dry etching, the regions may be also defined as spaces. In the first space accommodates the light blocking part and the second space accommodates the optical pattern, and, optionally, as described in the following, a transmission part.

An alternative definition of the invention is as follows: A display device includes a display element layer including a pixel-defining film and a light-emitting element, and a light control layer disposed on the display element layer in a thickness direction of the display device. The light control layer includes a light blocking part, an organic film and an optical pattern, wherein as seen in a cross-sectional view parallel to the thickness directions, that is a layer direction of the display element layer and the pixel defining film, the organic film is enclosed between the light blocking part and at least a part of the optical pattern. The organic film forms an undercut with the light blocking part in the thickness direction, that is a width of the light blocking part increases and a width of the organic film decreases in the thickness direction away from the display element layer. In the cross-sectional view, the light blocking part may have the form of a (inverted) trapezoid with the base directed away from the display element layer, especially an isosceles (inverted) trapezoid. The organic film may have the form of a triangle, especially an isosceles triangle. The light blocking part may be enclosed by two parts of the organic film, one part on either side. At least a part of the optical film may be on the outer side surface of the part of the organic film. The optical film or the part of the optical film may have a constant thickness. Different units of a light blocking part, two parts of the organic film and the optical pattern may be arranged with a distance to each other in the width direction and may preferably be enclosed by a transmission part as described below.

In an embodiment, the optical pattern includes a first patterned portion disposed in the second region and inclined with respect to the thickness direction, and a second patterned portion extending in the one direction from the first patterned portion.

In an embodiment, the second region includes a first sub-region and a second sub-region, and is provided in a plurality, the first patterned portion is disposed in the first sub-region, and the optical pattern further includes a third patterned portion extending from the second patterned portion and disposed in the second sub-region.

In an embodiment, the optical pattern includes at least one of a metal or an inorganic material.

In an embodiment, the optical pattern has a reflectance of about 10% or less.

In an embodiment, in a cross-section parallel to the thickness direction, the organic film, the light blocking part, and the optical pattern form a trapezoidal shape.

In an embodiment, the display device further includes a transmission part filling a remaining region other than one region in which the optical pattern is disposed in the second region.

In an embodiment, the transmission part is spaced apart from the organic film, with the optical pattern disposed therebetween, in the one direction.

In an embodiment, the transmission part includes a first portion disposed in the second region, and a second portion extending from the first portion and overlapping the light blocking part.

In an embodiment, an angle formed between a plane parallel to the thickness direction and an inner side surface of the organic film defining the second region is about 87° to about 89°.

In an embodiment, the light blocking part is provided as a plurality of light blocking parts which are spaced apart from each other in the one direction, and the light blocking parts each overlap at least one of the pixel-defining film or the light-emitting element.

In an embodiment, the pixel-defining film has a pixel opening defined therein, and the light-emitting element includes a first electrode exposed in the pixel opening, a second electrode disposed on the first electrode, and a light-emitting layer disposed between the first electrode and the second electrode.

According to an embodiment of the inventive concept, a display device includes a display element layer including a pixel-defining film and a light-emitting element, and a light control layer disposed on the display element layer in a thickness direction of the display device. The light control layer includes an organic film in which a first region and a second region at least partially spaced apart from each other in one direction perpendicular to the thickness direction are defined, a light blocking part disposed in the first region and including an upper surface and a lower surface facing each other in the thickness direction, and an optical pattern disposed on an inner side surface of the organic film defining the second region. In the one direction, a length of the upper surface of the light blocking part is greater than a length of the lower surface of the light blocking part, and the optical pattern includes one surface inclined with respect to the thickness direction.

In an embodiment, a first width of the organic film progressively decreases away from the display element layer along the thickness direction, and the first width is in the one direction.

In an embodiment, the optical pattern includes a first patterned portion disposed on the inner side surface of the organic film, and a second patterned portion extending from the first patterned portion in the one direction.

In an embodiment, the second region includes a first sub-region and a second sub-region, and is provided in a plurality, the first patterned portion is disposed in the first sub-region, and the optical pattern further comprises a third patterned portion extending from the second patterned portion and disposed in the second sub-region.

In an embodiment, the display device further includes a transmission part filling a remaining region other than one region in which the optical pattern is disposed in the second region.

In an embodiment, the optical pattern is disposed between the transmission part and the organic film, in the one direction.

In an embodiment, the transmission part includes a first portion disposed in the second region, and a second portion extending from the first portion and overlapping the light blocking part.

According to an embodiment of the inventive concept, an electronic device includes a processor, a memory having stored application programs for execution by the processor, a display device, and a user interface. The display device includes a display panel including a pixel-defining film and a light-emitting element, and a light control layer disposed on the display panel in a thickness direction of the display device. The light control layer includes an organic film in which a first region and a second region spaced apart from each other in one direction perpendicular to the thickness direction are defined, a light blocking part disposed in the first region, and an optical pattern disposed in the second region. A first width of the organic film progressively decreases away from the display panel along the thickness direction, a second width of the light blocking part progressively increases away from the display panel along the thickness direction, and the first width and the second width are in the one direction. The user interface is configured to sense user input via touch or cursor select of an icon presented on the display panel, and the processor is caused to execute one or more of the stored application programs upon receipt of the user input.

According to an embodiment of the inventive concept, a method of manufacturing a display device includes preparing a display element layer, and forming, on the display element layer in a thickness direction of the display device, a light control layer including an organic film in which a first region and a second region at least partially spaced apart from each other in one direction perpendicular to the thickness direction are defined, a light blocking part disposed to fill the first region, and an optical pattern disposed within the second region. The forming of the light control layer includes forming a first preliminary organic film on the display element layer, forming a second preliminary organic film having the first region defined therein by removing a portion of the first preliminary organic film, forming the light blocking part in the first region, forming the organic film having the first region and the second region defined therein by removing a portion of the second preliminary organic film, and forming the optical pattern in the second region. A first width of the organic film decreases in the one direction as the organic film is disposed farther away from the display element layer, a second width of the light blocking part increases in the one direction as the light blocking part is disposed farther away from the display element layer. Thus, forming a first preliminary organic film means that a preliminary organic film, especially a continues preliminary organic film, is formed on the display element layer and thereafter the first region or regions, in which the light blocking pattern is formed in a second or later step, is/are formed by removing the preliminary organic film in this first regions(s). Forming a second preliminary organic film means that the second region or regions, in which the optical pattern is formed in a later step, is/are formed by removing the preliminary organic film in this second regions(s).

In an embodiment, the method further includes forming a transmission part in the second region after the forming of the optical pattern. The transmission part is formed to fill a remaining region other than one region in which the optical pattern is formed within the second region.

The above and other features of the inventive concept will become more apparent by describing in detail embodiments thereof with reference to the accompanying drawings, in which:
FIG. 1 is a perspective view illustrating a display device according to an embodiment;
FIG. 2 is a cross-sectional view illustrating a portion taken along line I-I' of FIG. 1;
FIG. 3A is a plan view illustrating a portion of a display device according to an embodiment;
FIG. 3B is a plan view illustrating a portion of a display device according to an embodiment;
FIG. 4 is a cross-sectional view illustrating a portion taken along line II-II' of FIG. 3A;
FIG. 5 is an enlarged cross-sectional view illustrating region AA' of FIG. 4;
FIG. 6 is a cross-sectional view illustrating a display device according to an embodiment;
FIG. 7 is a cross-sectional view illustrating a display device according to an embodiment;
FIG. 8 is a view illustrating a vehicle in which a display device according to an embodiment is disposed;
FIG. 9A is a flowchart illustrating a method of manufacturing a display device according to an embodiment;
FIG. 9B is a flowchart illustrating a method of manufacturing a display device according to an embodiment;
FIG. 10 is a view schematically illustrating a display device manufacturing operation according to an embodiment;
FIG. 11 is a view schematically illustrating a display device manufacturing operation according to an embodiment;
FIG. 12 is a view schematically illustrating a display device manufacturing operation according to an embodiment;
FIG. 13 is a view schematically illustrating a display device manufacturing operation according to an embodiment;
FIG. 14 is a view schematically illustrating a display device manufacturing operation according to an embodiment;
FIG. 15 is a block diagram illustrating an electronic device according to an embodiment; and
FIG. 16 is a view illustrating electronic device according to various embodiments.

Embodiments of the inventive concept will be described more fully hereinafter with reference to the accompanying drawings. Like reference numerals may refer to like elements throughout the accompanying drawings.

It will be understood that the terms "first," "second," "third," etc. are used herein to distinguish one element from another, and the elements are not limited by these terms. Thus, a "first" element in an embodiment may be described as a "second" element in another embodiment.

It should be understood that descriptions of features or aspects within each embodiment should typically be considered as available for other similar features or aspects in other embodiments, unless the context clearly indicates otherwise.

As used herein, the singular forms "a", "an" and "the" are intended to include the plural forms as well, unless the context clearly indicates otherwise.

As used herein, the term "and/or" includes any and all combinations of one or more of the associated listed items. Expressions such as "at least one of," when preceding a list of elements, modify the entire list of elements and do not modify the individual elements of the list.

Spatially relative terms, such as "beneath", "below", "lower", "under", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below.

It will be understood that when a component is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other words used to describe the relationships between components should be interpreted in a like fashion.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art, for example, within ± 30%, 20%, 10% or 5% of the stated value. Further, it is to be understood that while parameters may be described herein as having "about" a certain value, according to embodiments, the parameter may be exactly the certain value or approximately the certain value within a measurement error as would be understood by a person having ordinary skill in the art. Other uses of these terms and similar terms to describe the relationships between components should be interpreted in a like fashion.

It will be understood that the term "includes" or "comprises", when used in this specification, specifies the presence of stated features, integers, steps, operations, elements, components, or a combination thereof, but does not preclude the presence or addition of one or more other features, integers, steps, operations, elements, components, or combinations thereof.

Embodiments of the inventive concept relate to a display device and a method of manufacturing the same, which utilize a light control layer that can improve display quality by improving light blocking characteristics. The light control layer may be disposed on a display element layer, and may include an organic film defining a first region and a second region, a light blocking part filling the first region, and an optical pattern disposed in the second region. The organic film, light blocking part, and optical pattern may collectively form a tapered light-blocking structure that can effectively limit the emission of light outside a predetermined angular range, which may improve privacy and reduce reflection.

Embodiments of the inventive concept may leverage a unique geometric design, where the width of the organic film decreases while the width of the light blocking part increases as the structure moves away from the display element layer. This inverted taper shape may provide excellent light-blocking properties and reduce light leakage. The optical pattern, including inclined surfaces, may improve the light control layer's ability to selectively block light while maintaining high display quality.

This innovative structure and its associated manufacturing method provided by embodiments of the inventive concept, which may involve multi-step etching and precise deposition of the light blocking part and optical pattern, may enable the production of display devices with improved performance. Embodiments may be utilized in, for example, vehicles, consumer electronics, and other devices in which controlled light emission and improved privacy features are a focus.

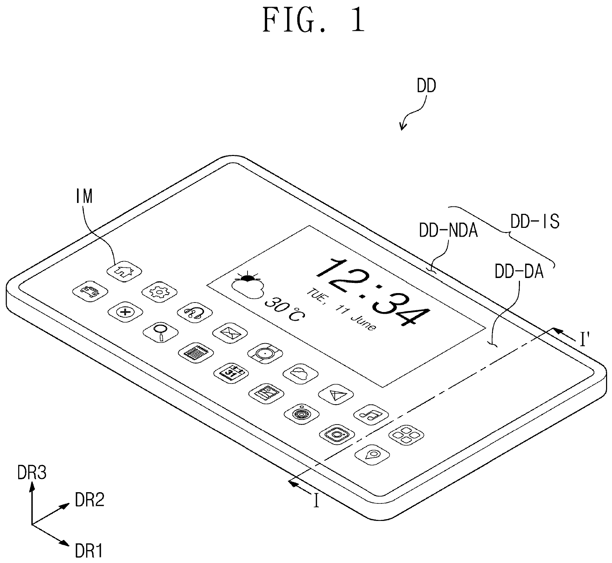

Hereinafter, a display device according to an embodiment of the inventive concept will be described with reference to the drawings. FIG. 1 is a perspective view illustrating a display device according to an embodiment.

Referring to FIG. 1, a display device DD according to an embodiment may be activated in response to an electrical signal. For example, the display device DD may be a device such as a television, a monitor, an outdoor billboard, a tablet computer, a vehicle navigation unit, a personal computer, a laptop computer, a personal digital terminal, a game console, a smartphone, and a camera. It is to be understood that these are merely presented as examples, and the display device DD may also be employed as other display devices without departing from the idea of the inventive concept. In this specification, an electronic device may be the display device DD or may include the display device DD.

The display device DD may display an image IM through a display surface DD-IS. The image IM may include not only a dynamic image (e.g., a video) but also a static image. The display surface DD-IS may be parallel to a plane defined by a first direction DR1 and a second direction DR2. FIG. 1 illustrates the display device DD provided with a flat display surface DD-IS. However, embodiments of the inventive concept are not limited thereto. For example, according to embodiments, the display device DD may also include a curved display surface or a three-dimensional display surface. The three-dimensional display surface may also include a plurality of display regions which respectively indicate different directions.

The display surface DD-IS may include a display region DD-DA and a non-display region DD-NDA. The display device DD may display the image IM through the display region DD-DA. The non-display region DD-NDA may be adjacent to the display region DD-DA, and the image IM is not displayed in the non-display region DD-NDA. The non-display region DD-NDA may surround the display region DD-DA. However, FIG. 1 is exemplarily illustrated, and the non-display region DD-NDA may be disposed adjacent to only one side of the display region DD-DA as well, as be omitted, according to embodiments.

In FIG. 1 and the following drawings, first to third direction axes DR1, DR2, and DR3 are illustrated, and directions indicated by the first to third direction axes DR1, DR2, and DR3 described herein may have a relative concept, and may thus be changed to other directions. Additionally, the directions indicated by the first to third direction axes DR1, DR2, and DR3 may be referred to as first to third directions, and may be denoted as the same reference numerals or symbols. In this specification, the first direction axis DR1 and the second direction axis DR2 may be orthogonal to each other, and the third direction axis DR3 may be a normal direction of a plane defined by the first direction axis DR1 and the second direction axis DR2.

The thickness direction of the display device DD corresponds to the third direction axis DR3. The upper side (or upper surface) refers to the side closer to the display surface DD-IS, while the lower side (or lower surface) refers to the side farther from the display surface DD-IS, both defined relative to the third direction axis DR3. A cross-section is a surface parallel to the thickness direction DR3, whereas a plane is a surface perpendicular to the thickness direction DR3. This plane is defined by the first direction axis DR1 and the second direction axis DR2.

In this specification, the wording "an element overlaps another element" means "overlapping on a plane". A case where an element overlaps another element is not limited to a case where the two elements have the same shape or area, and also includes a case where the two elements have different shapes and/or areas.

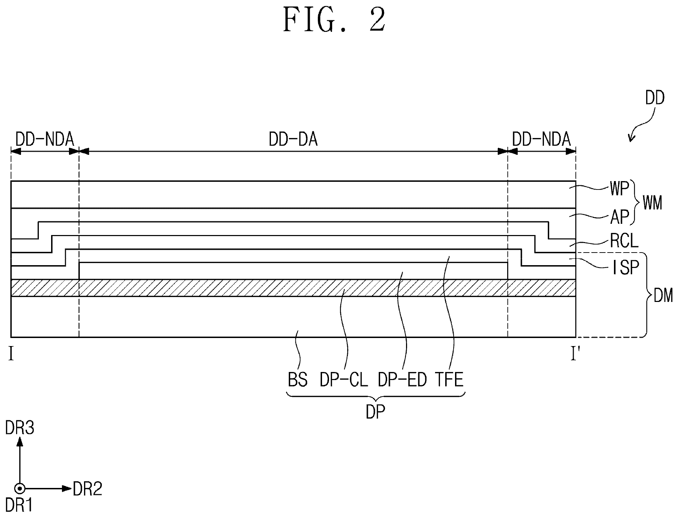

FIG. 2 is a cross-sectional view illustrating a portion taken along line I-I' of FIG. 1. FIG. 2 may be a cross-sectional view illustrating a display device DD according to an embodiment.

Referring to FIG. 2, the display device DD may include a display module DM, a light control layer RCL disposed on the display module DM, and a window member WM disposed on the light control layer RCL. The display module DM may include a display panel DP and an input-sensing layer ISP disposed on the display panel DP.

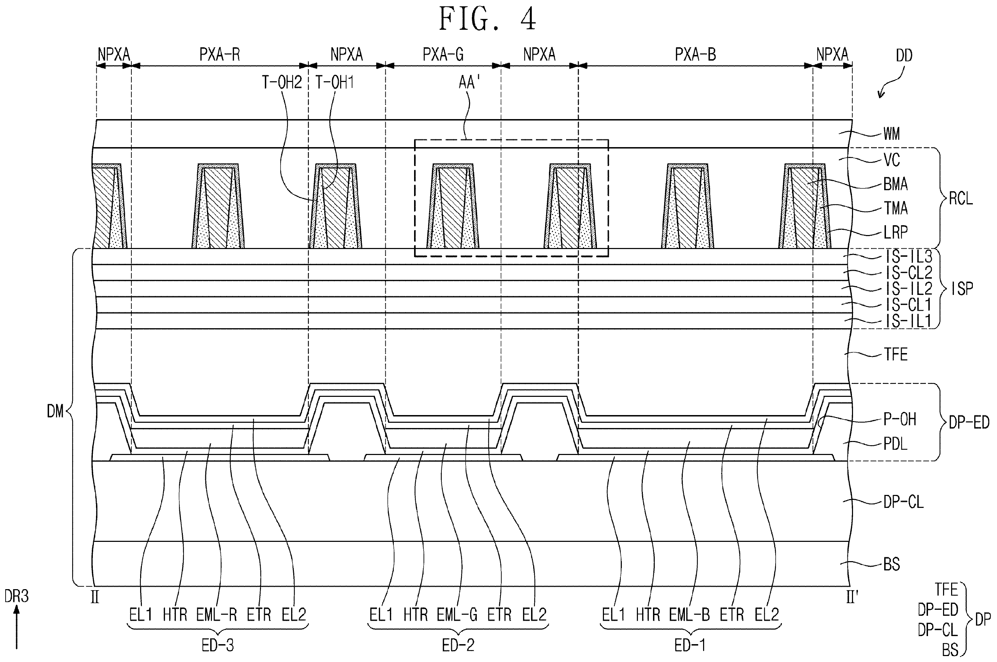

The display panel DP may substantially include at least one capacitor and a plurality of transistors that drive light-emitting elements ED-1, ED-2, and ED-3 (see FIG. 4). Each light-emitting element described herein may be implemented by, for example, an organic light-emitting diode (OLED). However, embodiments are not limited thereto. The display panel DP may be a component which substantially generates the image IM (see FIG. 1). The display panel DP may be a light-emitting display panel. For example, the display panel DP may be an organic light-emitting display panel, an inorganic light-emitting display panel, a quantum dot display panel, a micro LED display panel, or a nano LED display panel. The display panel DP may be referred to as a display layer. The display panel DP may include a base layer BS, a circuit layer DP-CL, a display element layer DP-ED, and an encapsulation layer TFE, which are sequentially stacked.

A base layer BS may be a member which provides a base surface on which the circuit layer DP-CL is disposed. The base layer BS may be a rigid substrate or a flexible substrate which is bendable, foldable, rollable, etc. The base layer BS may be, for example, a glass substrate, a metal substrate, a polymer substrate, etc. However, embodiments of the inventive concept are not limited thereto. For example, according to embodiments, the base layer BS may be an inorganic base layer, an organic base layer, or a composite material layer.

The circuit layer DP-CL may be disposed on the base layer BS. The circuit layer DP-CL may include, for example, an insulating layer, a semiconductor pattern, a conductive pattern, a signal line, etc. The insulating layer, the semiconductor layer, and the conductive layer are formed on the base layer BS through processes such as coating and deposition, and then the insulating layer, the semiconductor layer, and the conductive layer may be selectively patterned by performing photolithography multiple times. Thereafter, the semiconductor pattern, the conductive pattern, and the signal line included in the circuit layer DP-CL may be formed.

The display element layer DP-ED may be disposed on the circuit layer DP-CL. The display element layer DP-ED may include the light-emitting elements ED-1, ED-2, and ED-3 (see FIG. 4). For example, the display element layer DP-ED may include an organic light-emitting material, an inorganic light-emitting material, an organic-inorganic light-emitting material, quantum dots, or quantum rods. For example, the display element layer DP-ED may include a micro LED, or a nano LED.

The encapsulation layer TFE may be disposed on the display element layer DP-ED. The encapsulation layer TFE may protect the display element layer DP-ED against moisture, oxygen, and foreign substances such as dust particles.

The input-sensing layer ISP may be disposed on the display panel DP. The input-sensing layer ISP may detect an external input, change the detected external input to a predetermined input signal, and provide the input signal to the display panel DP. For example, in the display device DD according to an embodiment, the input-sensing layer ISP may be a touch-sensing part which detects a touch. The input-sensing layer ISP may recognize a direct touch by a user, an indirect touch by a user, a direct touch by an object, an indirect touch by an object, etc.

The input-sensing layer ISP may detect at least one of a position or an intensity (pressure) of an externally applied touch. The display panel DP may receive input signals from the input-sensing layer ISP and generate images corresponding to the input signals. For example, the input-sensing layer ISP may detect an external input in a capacitive manner. However, this is presented as an example, and a driving method of the input-sensing layer ISP is not limited thereto.

The input-sensing layer ISP may be formed on the display panel DP through a continuous process. In this case, the input-sensing layer ISP may be directly disposed on the display panel DP. That is, in an embodiment, an additional adhesive member is be disposed between the input-sensing layer ISP and the display panel DP. In an embodiment, the input-sensing layer ISP may also be bonded to the display panel DP via an adhesive member. The adhesive member may include a typical bonding agent or adhesive agent.

In this specification, when an element is referred to as being directly disposed/formed on another element, there is no intervening element therebetween. That is, the wording, "an element is 'directly disposed/formed on' another element" means that an element is 'in contact with' another element.

The light control layer RCL may limit an exit angle of light emitted from the display panel DP. The light control layer RCL may absorb (or block) light propagating at an angle falling out of a certain angle range and allow only light propagating at an angle falling within the certain angle range to be emitted. For example, the light control layer RCL may be a light control film (LCF) applied to a display device for a vehicle. The light control film (LCF) may prevent light, which is emitted from the display device DD, from being reflected at a windshield of a car and obstructing a driver's view. In an embodiment, the light control layer RCL may be a member provided to protect a user's personal privacy such that the image IM (see FIG. 1) is not visible to other people located around the user of the display device DD. For example, the light control layer RCL may be directly disposed on the display module DM.

The window member WM may be disposed on the display module DM. The window member WM may include a window WP, and an adhesive layer AP. The window member WM may further include at least one functional layer provided on the window WP. For example, the functional layer may be a hard coating layer, an anti-fingerprint coating layer, etc. However, embodiments of the inventive concept are not limited thereto.

The window WP may include an optically transparent insulating material. The window WP may be a glass substrate or a polymer substrate. For example, in an embodiment, the window WP may be a tempered glass substrate which has been subjected to reinforcement treatment. For example, in an embodiment, the window WP may be formed of polyimide, polyacrylate, polymethylmethacrylate, polycarbonate, polyethylenenaphthalate, polyvinylidene chloride, polyvinylidene difluoride, polystyrene, an ethylene vinylalcohol copolymer, or a combination thereof. However, this is presented as an example, and a material included in the window WP is not limited thereto.

The adhesive layer AP may be disposed between the display module DM and the window WP. A component adjacent to the window WP (for example, the display module DM and the light control layer RCL) may be bonded to the window WP via the adhesive layer AP. The adhesive layer AP may include a typical adhesive such as, for example, a pressure sensitive adhesive (PSA), an optically clear adhesive (OCA), and an optical clear resin (OCR), but is not limited thereto. Unlike what is illustrated, in an embodiment, the adhesive layer AP may also be omitted.

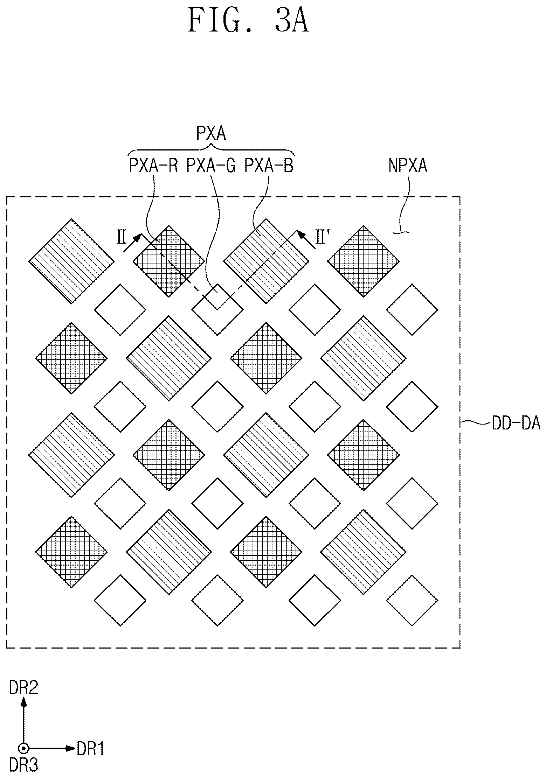

FIG. 3A is an enlarged plan view illustrating a part of a display region according to an embodiment. Referring to FIG. 3A, a display region DD-DA may be divided into a light-emitting region PXA and a peripheral region NPXA. The peripheral region NPXA may surround the light-emitting region PXA.

The light-emitting region PXA may be provided as a plurality of light-emitting regions which emit light having different wavelength ranges. The light-emitting region PXA may include a first light-emitting region PXA-B, a second light-emitting region PXA-G, and a third light-emitting region PXA-R. For example, the first light-emitting region PXA-B may emit blue light, the second light-emitting region PXA-G may emit green light, and the third light-emitting region PXA-R may emit red light. However, embodiments of the inventive concept are not limited thereto. For example, according to embodiments, the first to third light-emitting regions PXA-B, PXA-G, and PXA-R may also emit light having another color, other than red light, green light, and blue light.

In the light-emitting region PXA, the first light-emitting region PXA-B which emits blue light may have the greatest area, and the second light-emitting region PXA-G which emits green light may have the smallest area. In this case, the areas are considered as areas when viewed on a plane. However, this is presented as an example, and areas of the first to third light-emitting regions PXA-B, PXA-G, and PXA-R are not limited thereto.

FIG. 3A illustrates that the first light-emitting regions PXA-B and the third light-emitting regions PXA-R are alternately arranged in a first row along the second direction DR2, and the second light-emitting regions PXA-G are arranged in a second row to be spaced apart from the first light-emitting regions PXA-B and the third light-emitting regions PXA-R. However, this is presented as an example, and the arrangement of the first to third light-emitting regions PXA-B, PXA-G, and PXA-R is not limited thereto. Additionally, on a plane, shapes of the first to third light-emitting regions PXA-B, PXA-G, and PXA-R are not limited to those shown in the drawing, and may be defined as shapes different from those shown in the drawing.

The peripheral region NPXA may be regions which are between the adjacent light-emitting regions PXA-B, PXA-G, and PXA-R, and a region corresponding to a pixel-defining film PDL to be described in further detail below (see FIG. 4). The first to third light-emitting regions PXA-B, PXA-G, and PXA-R may respectively correspond to first to third light-emitting elements ED-1, ED-2, and ED-3 to be described in further detail below (see FIG. 4).

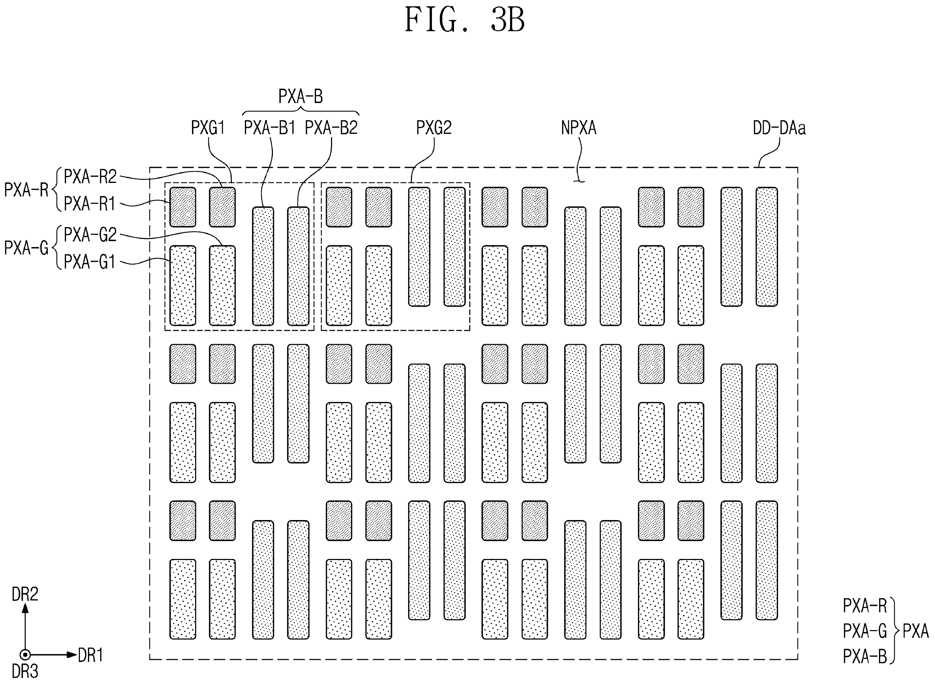

FIG. 3B is an enlarged plan view illustrating a part of a display region according to an embodiment of the inventive concept. Referring to FIG. 3B, first and second groups PXG1 and PXG2 may be disposed in a display region DD-DAa.

The first to third light-emitting regions PXA-B, PXA-G, and PXA-R may form the first and second groups PXG1 and PXG2. On a plane, the first group PXG1 and the second group PXG2 may be alternately disposed along the first direction DR1. Additionally, on a plane, the first group PXG1 and the second group PXG2 may be alternately disposed along the second direction DR2.

The first and second groups PXG1 and PXG2 may each include the first light-emitting region PXA-B, the second light-emitting region PXA-G, and the third light-emitting region PXA-R. According to embodiments, in the first direction DR1, edges of the first light-emitting region PXA-B of the first group PXG1 are not aligned with edges of the first light-emitting region PXA-B of the second group PXG2. In the first group PXG1, an edge of the first light-emitting region PXA-B may be aligned with an edge of the second light-emitting region PXA-G. In this case, an edge of the first light-emitting region PXA-B and an edge of the second light-emitting region PXA-G may be aligned with each other in the first direction DR1. In the second group PXG2, an edge of the first light-emitting region PXA-B may be aligned with an edge of the third light-emitting region PXA-R. In this case, an edge of the first light-emitting region PXA-B and an edge of the third light-emitting region PXA-R may be aligned with each other in the first direction DR1.

In each of the first and second groups PXG1 and PXG2, the first light-emitting region PXA-B may include a first blue-light-emitting region PXA-B 1 and a second blue-light-emitting region PXA-B2. In each of the first and second groups PXG1 and PXG2, the first blue-light-emitting region PXA-B 1 and the second blue-light-emitting region PXA-B2 may be spaced apart from each other along the first direction DR1. On a plane, the area of the first blue-light-emitting region PXA-B1 may be substantially the same as the area of the second lue-light-emitting region PXA-B2. In this specification, the wording "substantially the same" includes a case where physical values are the same and a case where a difference falls within a process tolerance range.

In each of the first and second groups PXG1 and PXG2, the second light-emitting region PXA-G may include a first green-light-emitting region PXA-G1 and a second green-light-emitting region PXA-G2. In each of the first and second groups PXG1 and PXG2, the first green-light-emitting region PXA-G1 and the second green-light-emitting region PXA-G2 may be spaced apart from each other along the first direction DR1. On a plane, the area of the first green-light-emitting region PXA-G1 may be substantially the same as the area of the second green-light-emitting region PXA-G2.

In each of the first and second groups PXG1 and PXG2, the third light-emitting region PXA-R may include a first red-light-emitting region PXA-R1 and a second red-light-emitting region PXA-R2. In each of the first and second groups PXG1 and PXG2, the first red-light-emitting region PXA-R1 and the second red-light-emitting region PXA-R2 may be spaced apart from each other along the first direction DR1. On a plane, the area of the first red-light-emitting region PXA-R1 may be substantially the same as the area of the second red-light-emitting region PXA-R2.

For example, a light-emitting mode of the display device DD may include a first mode and a second mode. The first mode may be a privacy mode in which an exit angle of light is limited, and the second mode may be a general mode in which an exit angle of light is not limited. One light-emitting region among two light-emitting regions which emit light having the same color may not emit light in a particular mode. One light-emitting element among the two light-emitting elements disposed so as to correspond to each of two light-emitting regions which emit light having the same color may not emit light in a particular mode.

For example, in an embodiment, one light-emitting region among the two light-emitting regions which emit light having the same color may emit light in the first and second modes, and the other light-emitting region may emit light in the first mode and not emit light in the second mode. In an embodiment, one light-emitting region among the two light-emitting regions which emit light having the same color may emit light in the first mode and not emit light in the second mode, and the other light-emitting region may not emit light in the first mode and may emit light in the second mode.

In an embodiment, the first blue-light-emitting region PXA-B 1 may emit light in the first and second modes, and the second blue-light-emitting region PXA-B2 may emit light in the first mode and not emit light in the second mode. In an embodiment, the first blue-light-emitting region PXA-B 1 may emit light in the first mode and not emit light in the second mode, and the second blue-light-emitting region PXA-B2 may not emit light in the first mode and may emit light in the second mode. The above description may be similarly applied to the first and second green-light-emitting regions PXA-G1 and PXA-G2, and the first and second red-light-emitting regions PXA-R1 and PXA-R2.

FIG. 4 is a cross-sectional view illustrating a portion taken along line II-II' of FIG. 3A. In FIG. 4, components such as a light control layer RCL, etc., are illustrated in detail.

A base layer BS may have a single- or multi-layered structure. For example, the base layer BS may include a first synthetic resin layer, an intermediate layer having a multi- or single-layered structure, and a second synthetic resin layer, which are sequentially stacked. The intermediate layer may be referred to as a base barrier layer. The intermediate layer may include a silicon oxide (SiOₓ) layer and an amorphous silicon (a-Si) layer disposed on the silicon oxide layer, but is not particularly limited thereto. For example, the intermediate layer may include at least one of a silicon oxide layer, a silicon nitride layer, a silicon oxynitride layer, or an amorphous silicon layer.

The first and second synthetic resin layers may each include a polyimide-based resin. Additionally, the first and second synthetic resin layers may each include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin. In this specification, a "~~based" resin is considered as including a functional group of "~~".

A circuit layer DP-CL may include a plurality of transistors. The transistors may each include a control electrode, an input electrode, and an output electrode. For example, the circuit layer DP-CL may include a switching transistor or a driving transistor that drives light-emitting elements ED-1, ED-2, and ED-3 of a display element layer DP-ED.

The display element layer DP-ED may include the light-emitting elements ED-1, ED-2, and ED-3, and a pixel-defining film PDL. A pixel opening P-OH may be defined in the pixel-defining film PDL. For example, the pixel-defining film PDL may include an organic light blocking material or an inorganic light blocking material which includes a black pigment or a black dye. The light-emitting regions PXA-B, PXA-G, and PXA-R may each be separated by the pixel-defining films PDL. The peripheral region NPXA may be regions which are disposed between the adjacent light-emitting regions PXA-B, PXA-G, and PXA-R, and a region corresponding to the pixel-defining film PDL.

The pixel-defining films PDL may separate first to third light-emitting elements ED-1, ED-2, and ED-3. Light-emitting layers EML-B, EML-G, and EML-R of the first to third light-emitting elements ED-1, ED-2, and ED-3 may be disposed in the pixel openings P-OH defined by the pixel-defining films PDL and be separated from each other.

The display element layer DP-ED may include the first to third light-emitting elements ED-1, ED-2, and ED-3. The first to third light-emitting elements ED-1, ED-2, and ED-3 may be spaced apart from each other in one direction perpendicular to the thickness direction DR3. The first to third light-emitting elements ED-1, ED-2, and ED-3 may each include a first electrode EL1, a second electrode EL2 disposed on the first electrode EL1, and the light-emitting layers EML-B, EML-G, and EML-R disposed between the first electrode EL1 and the second electrode EL2. Additionally, the first to third light-emitting elements ED-1, ED-2, and ED-3 may each further include a hole transport region HTR disposed between the first electrode EL1 and the light-emitting layers EML-B, EML-G, and EML-R, and an electron transport region ETR disposed between the light-emitting layers EML-B, EML-G, and EML-R and the second electrode EL2.

The first to third light-emitting elements ED-1, ED-2, and ED-3 may emit light having wavelength ranges different from each other. The first light-emitting element ED-1 may include a first light-emitting layer EML-B which emits first light. The second light-emitting element ED-2 may include a second light-emitting layer EML-G which emits second light different from the first light. The third light-emitting element ED-3 may include a third light-emitting layer EML-R which emits third light different from the first light and the second light. The first light may be blue light, the second light may be green light, and the third light may be red light. However, embodiments of the inventive concept are not limited thereto. The first to third light-emitting elements ED-1, ED-2, and ED-3 may emit light having the same wavelength range, or at least one thereof may emit light having a different wavelength range. For example, all the first to third light-emitting elements ED-1, ED-2, and ED-3 may emit blue light or white light.

At least a portion of the first electrode EL1 may be exposed in the pixel opening P-OH. The first electrode EL1 may be formed of, for example, a metal material, a metal alloy, or a conductive compound. The first electrode EL1 may be an anode or a cathode. The first electrode EL1 may be a pixel electrode. The first electrode EL1 may be, for example, a transmissive electrode, a transflective electrode, or a reflective electrode.

The first electrode EL1 may include at least one of, for example, Ag, Mg, Cu, Al, Pt, Pd, Au, Ni, Nd, Ir, Cr, Li, Ca, LiF, Mo, Ti, W, In, Sn, and Zn, a compound of two or more materials selected from thereamong, a mixture of two or more materials selected from thereamong, or an oxide thereof.

When the first electrode EL1 is the transmissive electrode, the first electrode EL1 may include a transparent metal oxide, for example, indium tin oxide (ITO), indium zinc oxide (IZO), zinc oxide (ZnO), indium tin zinc oxide (ITZO), etc.

When the first electrode EL1 is the transflective electrode or the reflective electrode, the first electrode EL1 may include, for example, Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or mixture thereof (for example, a mixture of Ag and Mg). In an embodiment, the first electrode EL1 may have a multi-layered structure including a reflective film or a transflective film, which is formed of the above-described materials, and a transparent conductive film formed of, for example, indium tin oxide (ITO), indium zinc oxide (IZO), zinc oxide (ZnO), indium tin zinc oxide (ITZO), etc. For example, the first electrode EL1 may have a three-layered structure of ITO/Ag/ITO, but is not limited thereto. However, embodiments of the inventive concept are not limited thereto. For example, according to embodiments, the first electrodes EL1 may each include the above-described metal materials, a combination of two or more metal materials from the above-described materials, oxides of the above-described metal materials, etc.

The hole transport region HTR may be formed of a typical hole injection material and/or a typical hole transport material. The hole transport region HTR may include at least one of a hole injection layer, a hole transport layer, or an electron blocking layer. The hole transport region HTR may entirely overlap the light-emitting regions PXA-B, PXA-G, and PXA-R, and the peripheral region NPXA. That is, the hole transport region HTR may be provided as a common layer so as to overlap the light-emitting regions PXA-B, PXA-G, and PXA-R, and the peripheral region NPXA. However, embodiments of the inventive concept are not limited thereto. For example, according to embodiments, the patterned hole transport regions HTR may be provided such that the hole transport regions HTR are separated from each other to respectively correspond to the light-emitting regions PXA-B, PXA-G, and PXA-R.

The first to third light-emitting layers EML-B, EML-G, and EML-R may each include an organic light-emitting material or an inorganic light-emitting material. For example, the first to third light-emitting layers EML-B, EML-G, and EML-R may each include a fluorescent or phosphorescent light-emitting material. Also, the first to third light-emitting layers EML-B, EML-G, and EML-R may each include quantum dots as a light-emitting material.

The electron transport region ETR may be formed of a typical electron injection material and/or a typical electron transport material. The electron transport region ETR may include at least one of an electron injection layer, an electron transport layer, or a hole blocking layer. The electron transport region ETR may entirely overlap the light-emitting regions PXA-B, PXA-G, and PXA-R, and the peripheral region NPXA. That is, the electron transport region ETR may be provided as a common layer so as to overlap the light-emitting regions PXA-B, PXA-G, and PXA-R, and the peripheral region NPXA. However, embodiments of the inventive concept are not limited thereto. For example, according to embodiments, the patterned electron transport regions ETR may be provided such that the electron transport regions ETR are separated from each other to respectively correspond to the light-emitting regions PXA-B, PXA-G, and PXA-R.

The second electrode EL2 may be a common electrode. The second electrode EL2 may be a cathode or an anode. However, embodiments of the inventive concept are not limited thereto. For example, according to embodiments, when the first electrode EL1 is an anode, the second electrode EL2 may be a cathode, and when the first electrode EL1 is a cathode, the second electrode EL2 may be an anode. The second electrode EL2 may be a transmissive electrode, a transflective electrode or a reflective electrode. When the second electrode EL2 is the transmissive electrode, the second electrode EL2 may be formed of a transparent metal oxide such as, for example, indium tin oxide (ITO), indium zinc oxide (IZO), zinc oxide (ZnO), indium tin zinc oxide (ITZO), etc.

When the second electrode EL2 is the transflective electrode or the reflective electrode, the second electrode EL2 may include, for example, Ag, Mg, Cu, Al, Pt, Pd, Au, Ni, Nd, Ir, Cr, Li, Ca, LiF/Ca, LiF/Al, Mo, Ti, Yb, W, or a compound or a mixture thereof (for example, AgMg, AgYb, or MgYb). In an embodiment, the second electrode EL2 may have a multi-layered structure including a reflective film or a transflective film, which is formed of the above-described materials, and a transparent conductive film formed of, for example, indium tin oxide (ITO), indium zinc oxide (IZO), zinc oxide (ZnO), indium tin zinc oxide (ITZO), etc. For example, the second electrode EL2 may include the above-described metal materials, a combination of two or more metal materials selected from the above-described materials, oxides of the above-described metal materials, etc.

According to embodiments, a capping layer may be disposed on the first to third light-emitting elements ED-1, ED-2, and ED-3. The capping layer may be an organic capping layer or an inorganic capping layer. For example, when the capping layer includes an inorganic material, the inorganic material may include an alkali metal compound such as, for example, LiF, an alkali earth-metal compound such as MgF₂, or SiON, SiNₓ, SiO_{y}, etc. For example, when the capping layer includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-Tris(carbazol-9-yl)triphenylamine (TCTA), etc., or may include an epoxy resin or acrylate such as methacrylate.

An encapsulation layer TFE may be disposed on the display element layer DP-ED. The encapsulation layer TFE may include at least one inorganic film (hereinafter, an inorganic encapsulation film). Additionally, the encapsulation layer TFE may include at least one organic film (hereinafter, an organic encapsulation film) and at least one inorganic encapsulation film.

The inorganic encapsulation film may protect the display element layer DP-ED against moisture/oxygen, and the organic encapsulation film may protect the display element layer DP-ED against foreign substances such as dust particles. The inorganic encapsulation film may include, for example, silicon nitride, silicon oxynitride, silicon oxide, titanium oxide, aluminum oxide, or the like, and is not particularly limited thereto. The organic encapsulation film may include an acryl-based compound, an epoxy-based compound, etc. The organic encapsulation film may include a photopolymerizable organic material, and is not particularly limited.

An input-sensing layer ISP may be disposed on the encapsulation layer TFE. The input-sensing layer ISP may include first to third insulating layers IS-IL1, IS-IL2, and IS-IL3, a first conductive layer IS-CL1, and a second conductive layer IS-CL2.

The first insulating layer IS-IL1 may include at least one inorganic insulating layer. The first insulating layer IS-IL1 may be in contact with the encapsulation layer TFE. Unlike what illustrated, according to embodiments, the first insulating layer IS-IL1 may also be omitted, and in this case, the first conductive layer IS-CL1 may be in contact with the encapsulation layer TFE.

The first conductive layer IS-CL1 may be disposed on the first insulating layer IS-IL1. The first conductive layer IS-CL1 may include a plurality of first conductive patterns. The plurality of first conductive patterns may be disposed on the first insulating layer IS-IL1. The second insulating layer IS-IL2 may be disposed on the first insulating layer IS-IL1.

The second conductive layer IS-CL2 may be disposed on the second insulating layer IS-IL2. The second conductive layer IS-CL2 may include a plurality of second conductive patterns. The plurality of second conductive patterns may be disposed on the second insulating layer IS-IL2. The plurality of first conductive patterns of the first conductive layer IS-CL1, and the plurality of second conductive patterns of the second conductive layer IS-CL2, may each correspond to a mesh pattern.

The third insulating layer IS-IL3 may be disposed on the second insulating layer IS-IL2. The second insulating layer IS-IL2 and the third insulating layer IS-IL3 may each include an inorganic insulating layer or an organic insulating layer.

The first conductive layer IS-CL1 and the second conductive layer IS-CL2 may each have a single-layered structure or a multi-layered structure in which layers are stacked along the thickness direction DR3. The conductive layers IS-CL1 and IS-CL2 having a single-layered structure may include a metal layer or a transparent conductive layer. The metal layer may include, for example, molybdenum, silver, titanium, copper, aluminum, or an alloy thereof. The transparent conductive layer may include a transparent conductive oxide such as, for example, indium tin oxide (ITO), indium zinc oxide (IZO), zinc oxide (ZnO), and indium zinc tin oxide (IZTO). Additionally, the transparent conductive layer may include a conductive polymer such as, for example, PEDOT, a metal nanowire, graphene, etc.

The conductive layers IS-CL1 and IS-CL2 having a multi-layered structure may include metal layers. For example, the metal layers may have a three-layered structure of titanium (Ti)/aluminum (Al)/titanium (Ti). The conductive layers IS-CL1 and IS-CL2 having a multi-layered structure may include at least one metal layer and at least one transparent conductive layer.

A light control layer RCL may be disposed on the input-sensing layer ISP. The light control layer RCL may be formed on the input-sensing layer ISP through a continuous process. In this case, the light control layer RCL may be directly disposed on the input-sensing layer ISP.

In an embodiment, the light control layer RCL may include an organic film TMA, a light blocking part BMA, and an optical pattern LRP. The light control layer RCL may further include a transmission part VC.

The organic film TMA may transmit light. The organic film TMA may be referred to as a sub-transmission part. The organic film TMA may be optically transparent. The organic film TMA may include an optically transparent organic material. For example, the organic film TMA may include at least one of a polyimide-based resin, an acyl-based resin, or a siloxane-based resin. However, this is presented as an example, and a material included in the organic film TMA is not limited thereto. An upper surface of the organic film TMA may be disposed below an upper surface of the optical pattern LRP in the thickness direction DR3. That is, the upper surface of the optical pattern LRP may be further adjacent to the display surface DD-IS (see FIG. 1) than the upper surface of the organic film TMA. The thickness of the organic film TMA may be equal to or smaller than the thickness of the light blocking part BMA in the thickness direction DR3. For example, the upper surface of the organic film TMA may be disposed on the substantially same plane as the upper surface of the light blocking part BMA.

A first region T-OH1 and a second region T-OH2 may be defined in the organic film TMA. The first region T-OH1 and the second region T-OH2 may be spaced apart from each other in one direction perpendicular to the thickness direction DR3. The first region T-OH1 may be a region which passes through from the upper surface of the organic film TMA to a lower surface of the organic film TMA. The second region T-OH2 may be a region which passes through from the upper surface of the organic film TMA to the lower surface of the organic film TMA. The first and second regions T-OH1 and T-OH2 may also be respectively referred to as first and second openings. A width of each of the first and second regions T-OH1 and T-OH2 may increase the regions get farther away from the display element layer DP-ED. A width of each of the first and second regions T-OH1 and T-OH2 may be in one direction perpendicular to the thickness direction DR3. The light blocking part BMA may be disposed in the first region T-OH1, and the optical pattern LRP may be disposed in the second region T-OH2.

The light blocking part BMA may be formed by adopting a light absorbing material. For example, a dark-colored pigment such as a black pigment or a gray pigment, a dark-colored dye, a metal such as aluminum or silver, a metal oxide, a dark-colored polymer, etc., may be used as the light absorbing material.

The light blocking part BMA may be provided in plurality. The plurality of light blocking parts BMA may be spaced apart from each other at about equal intervals in one direction perpendicular to the thickness direction DR3. The plurality of light blocking parts BMA may each overlap at least one among the pixel-defining films PDL and the light-emitting elements ED-1, ED-2, and ED-3. At least one light blocking part BMA may overlap at least one among the light-emitting elements ED-1, ED-2, and ED-3.

The optical pattern LRP may include a metal or an inorganic material. The optical pattern LRP may be spaced apart from the light blocking part BMA with the organic film TMA disposed therebetween in one direction perpendicular to the thickness direction DR3. The optical pattern LRP may be in contact with the light blocking part BMA in the thickness direction DR3. A width of the optical pattern LRP may be uniform in one direction perpendicular to the thickness direction DR3. A width of the optical pattern LRP may be uniform in the thickness direction DR3.

The transmission part VC may be disposed in the second region T-OH2 of the organic film TMA. The transmission part VC may be formed to fill a remaining region other than one region in which the optical pattern LRP is disposed within the second region T-OH2. The transmission part VC may be in contact with the optical pattern LRP within the second region T-OH2. The transmission part VC may be a planarized layer. An upper surface of the transmission part VC may define an upper surface of the light control layer RCL.

In a cross-section, the organic film TMA, the light blocking part BMA, and the optical pattern LRP may form a trapezoidal shape. The transmission part VC may be disposed so as to surround a trapezoid-shaped structure. The transmission part VC may be disposed on an upper surface of a trapezoid-shaped structure while surrounding a side surface of the trapezoid-shaped structure. The transmission part VC may surround the side surface of the trapezoid-shaped structure within the second region T-OH2.

The transmission part VC may transmit light. The transmission part VC may include an optically transparent organic material. In an embodiment, the transmission part VC may include the same organic material as the organic film TMA. In an embodiment, the transmission part VC may include a different organic material from the organic film TMA.

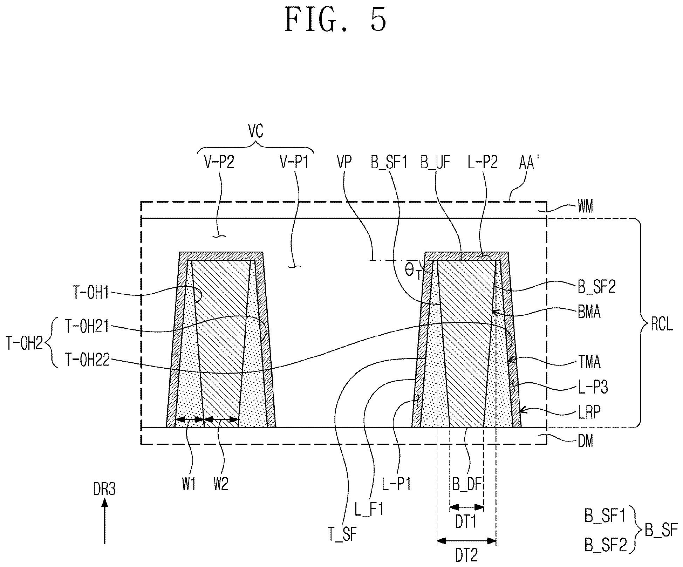

FIG. 5 is an enlarged cross-sectional view illustrating region AA' of FIG. 4. Referring to FIG. 5, a first width W1 of the organic film TMA may decrease as the organic film TMA is disposed farther away from the display module DM. A second width W2 of the light blocking part BMA may increase as the light blocking part BMA is disposed farther away from the display module DM. For example, the first width W1 of the organic film TMA may progressively decrease away from the display element layer DP-ED along the thickness direction DR3, and the second width W2 of the light blocking part BMA may progressively increase away from the display element layer DP-ED along the thickness direction DR3. The first and second widths W1 and W2 may each be in one direction perpendicular to the thickness direction DR3. The first width W1 of the organic film TMA may progressively decrease as the organic film TMA is disposed farther away from the display element layer DP-ED (see FIG. 4) included in the display module DM, and the second width W2 of the light blocking part BMA may progressively increase as the light blocking part BMA is disposed farther away from the display element layer DP-ED (see FIG. 4) included in the display module DM.

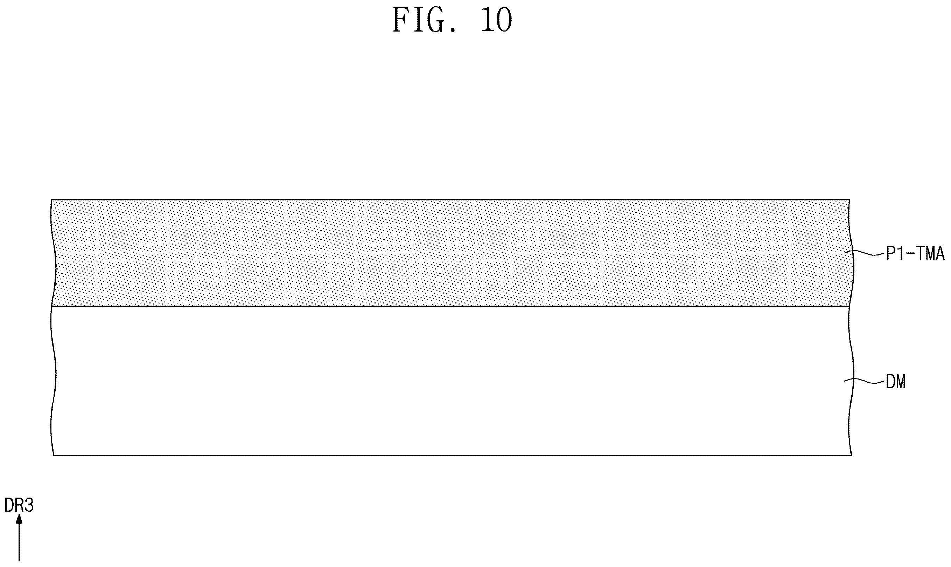

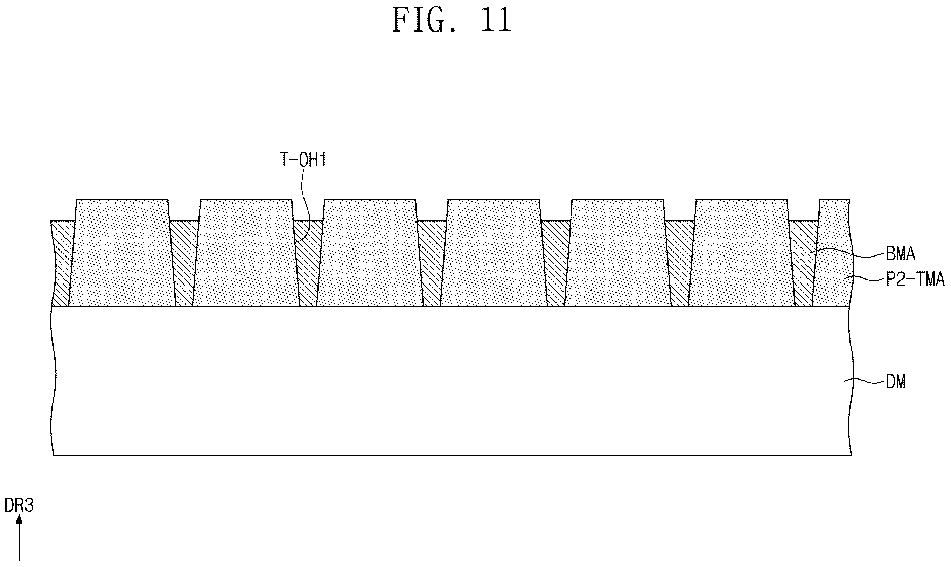

The first and second regions T-OH1 and T-OH2 may be defined in the organic film TMA, and the first and second regions T-OH1 and T-OH2 may be formed in different operations during a manufacturing process. A first preliminary organic film P1-TMA (see FIG. 10) having a predetermined thickness may be formed, and then a second preliminary organic film P2-TMA (see FIG. 11) having the first region T-OH1 defined therein may be formed by performing an etching process on the first preliminary organic film P1-TMA (see FIG. 10). The organic film TMA having the first and second regions T-OH1 and T-OH2 defined therein may be formed by performing an etching process on the second preliminary organic film P2-TMA (see FIG. 11). When the etching process is performed on the first and second preliminary organic films P1-TMA and P2-TMA (see FIGS. 10 and 11) having a predetermined thickness, an etching width may vary according to a depth. Due to a characteristic of an etching process, the more a depth of a member having a predetermined thickness increases, the more a straightness of an etching direction deteriorates, which results in a decrease in an etching width. The etching width means a width in one direction perpendicular to the thickness direction DR3. A point having a large depth is considered as a region positioned at a lower part in the thickness direction DR3, and a point having a small depth is considered as a region positioned at an upper part in the thickness direction DR3. When an etching process is performed in a direction from the upper part to the lower part, due to a characteristic of an etching process, the etching width decreases as the etching process is performed downward.

The first region T-OH1 and the second region T-OH2 may be spaced apart from each other in one direction perpendicular to the thickness direction DR3. The first and second regions T-OH1 and T-OH2 formed through an etching process may each have a width which increases as getting farther away from the display module DM. Accordingly, the first width W1 of the organic film TMA having the first and second regions T-OH1 and T-OH2 defined therein may decrease as getting farther away from the display module DM. An angle θ_{T} formed between one plane VP perpendicular to the thickness direction DR3 and an inner side surface T_SF of the organic film TMA defining the second region T-OH2 may be about 87° to about 89°. The one plane VP illustrated in FIG. 5 may be a virtual surface and be perpendicular to the thickness direction DR3.

The light blocking part BMA may be disposed to fill the first region T-OH1. A width of the first region T-OH1 formed through an etching process may increase as the first region T-OH1 gets farther away from the display module DM. Accordingly, the light blocking part BMA disposed to fill the first region T-OH1 may have the second width W2 which increases as the first region T-OH1 is disposed farther away from the display module DM.

In a cross-section, the light blocking part BMA may have an inverted trapezoidal (or tapered) shape including an inclined side surface B_SF. The light blocking part BMA may include a lower surface B_DF adjacent to the display module DM, an upper surface B_UF disposed on the lower surface B_DF, and the side surface B_SF disposed between the lower surface B_DF and the upper surface B_UF. The lower surface B_DF, the upper surface B_UF, and the side surface B_SF may have an integral shape. The lower surface B_DF and the upper surface B_UF of the light blocking part BMA may face each other in the thickness direction DR3. In a cross-section, the length DT2 of the upper surface B_UF of the light blocking part BMA may be greater than the length DT1 of the lower surface B_DF of the light blocking part BMA. The length DT2 of the upper surface B_UF of the light blocking part BMA and the length DT1 of the lower surface B_DF of the light blocking part BMA may each be a length in one direction perpendicular to the thickness direction DR3.

The side surface B_SF of the light blocking part BMA may be inclined with respect to the thickness direction DR3. In the light blocking part BMA, an angle formed between the side surface B_SF and the upper surface B_UF may be greater than about 0° and less than about 90°. In the light blocking part BMA, an angle formed between the side surface B_SF and the upper surface B_UF may be an interior angle of the trapezoid. In a cross-section, the side surface B_SF of the light blocking part BMA may include first and second side surfaces B_SF1 and B_SF2.

The optical pattern LRP may be disposed parallel to the side surface B_SF of the light blocking part BMA. The optical pattern LRP may include a first patterned portion L-P1 and a second patterned portion L-P2 extending from the first patterned portion L-P1. Additionally, the optical pattern LRP may further include a third patterned portion L-P3 extending from the second patterned portion L-P2. The first to third patterned portions L-P1, L-P2, and L-P3 may have an integral shape.

The second region T-OH2 may be provided in plurality. The second region T-OH2 may include first and second sub-regions T-OH21 and T-OH22 spaced apart from each other in one direction perpendicular to the thickness direction DR3.

The first and third patterned portions L-P1 and L-P3 may be portions which are disposed within the second region T-OH2 and are inclined with respect to the thickness direction DR3. The first and third patterned portions L-P1 and L-P3 may be portions which are inclined in a direction not perpendicular and parallel to the thickness direction DR3. One surface L_F1 of the first patterned portion L-P1 may be inclined with respect to the thickness direction DR3. The first patterned portion L-P1 may be disposed within the first sub-region T-OH21. The first patterned portion L-P1 may be disposed on the inner side surface T_SF, of the organic film TMA, defining the second region T-OH2. The first patterned portion L-P1 may be directly disposed on the inner side surface T_SF, of the organic film TMA, defining the second region T-OH2. The first patterned portion L-P1 may be spaced apart from the second side surface B_SF2 of the light blocking part BMA with the first side surface B_SF1 of the light blocking part BMA therebetween. The first patterned portion L-P1 may be disposed parallel to the second side surface B_SF2 of the light blocking part BMA. However, this is presented as an example, and the first patterned portion L-P1 may also not be parallel to the second side surface B_SF2 of the light blocking part BMA according to embodiments.

The third patterned portion L-P3 may be disposed on the inner side surface T_SF, of the organic film TMA, defining the second region T-OH2. The third patterned portion L-P3 may be disposed within the second sub-region T-OH22. The third patterned portion L-P3 may be spaced apart from the first side surface B_SF1 of the light blocking part BMA with the second side surface B_SF2 of the light blocking part BMA therebetween. The third patterned portion L-P3 may be disposed parallel to the first side surface B_SF1 of the light blocking part BMA. However, this is presented as an example, and the third patterned portion L-P3 may also not be parallel to the first side surface B_SF1 of the light blocking part BMA according to embodiments.

The second patterned portion L-P2 may be disposed on the upper surface B_UF of the light blocking part BMA. The second patterned portion L-P2 may be in contact with the upper surface B_UF of the light blocking part BMA. The second patterned portion L-P2 may overlap the first region T-OH1. The second patterned portion L-P2 may extend parallel to one direction perpendicular to the thickness direction DR3. In a cross-section, the first to third patterned portions L-P1, L-P2, and L-P3 may form a trapezoidal (or tapered) shape.

The optical pattern LRP which includes a portion inclined with respect to the thickness direction DR3 (that is, the first patterned portion L-P1 and/or the third patterned portion L-P3) may block light, propagating at an angle falling out of a certain angle range, from being emitted. The optical pattern LRP may have a reflectance of about 10% or less. For example, in the optical pattern LRP, each of the specular component included (SCI) and specular component excluded (SCE) reflectance values may be about 10% or less. The optical pattern LRP having a reflectance of about 10% or less may exhibit excellent light blocking properties.

The optical pattern LRP may include at least one of a metal or an inorganic material. For example, the optical pattern LRP may include at least one of a Si-containing inorganic material, an In-containing inorganic material, or aluminum (Al). However, this is presented as an example. For example, according to embodiments, a metal or an inorganic material may be applied to the optical pattern LRP as a forming material as long as having a reflectance of about 10% or less.

In a cross-section, the organic film TMA, the light blocking part BMA, and the optical pattern LRP may form a trapezoidal shape. One light blocking part BMA, a portion of the organic film TMA adjacent to the one light blocking part BMA, and one optical pattern LRP adjacent to the one light blocking part BMA form a trapezoid-shaped structure, and thus the trapezoid-shaped structure may limit light, propagating at an angle falling out of a certain angle range, from being emitted. Accordingly, the light control layer RCL which includes the organic film TMA, the light blocking part BMA, and the optical pattern LRP according to an embodiment may exhibit excellent light blocking properties. A display device DD including the light control layer RCL according to an embodiment may exhibit excellent display quality.

For example, according to embodiments, in a cross-section, the organic film TMA, the light blocking part BMA, and the optical pattern LRP may collectively form a trapezoidal structure, in which a single light blocking part BMA, the adjacent portion of the organic film TMA, and an adjacent optical pattern LRP create a trapezoid-shaped configuration. This configuration may effectively restrict the emission of light that propagates at angles outside a defined angular range. As a result, the light control layer RCL - including the organic film TMA, the light blocking part BMA, and the optical pattern LRP according to an embodiment - may demonstrate improved light-blocking capabilities. Thus, a display device DD incorporating the light control layer RCL as described above may provide exceptional display quality.

On the contrary, a display device not including an optical pattern, and including a transmission part and a light blocking part which is disposed to fill an opening defined in the transmission part and has an inverted trapezoidal shape has decreased light blocking properties. The light blocking part having an inverted trapezoidal shape limits light, propagating at an angle falling out of a certain angle range, from being emitted, but the limited angle range is extremely small, which results in a decrease in the light blocking properties. The display device DD according to an embodiment includes the organic film TMA, the light blocking part BMA, and the optical pattern LRP which form a trapezoidal shape, and may thus exhibit excellent display quality.

For example, in the organic film TMA formed by performing an etching process twice, an upper part region, of the organic film TMA, adjacent to the display surface DD-IS (see FIG. 1), may have an extremely small width. This upper part region of the organic film TMA is a region adjacent to the upper surface B_UF of the light blocking part BMA, and may serve as the starting point of the etching process. In a region adjacent to the upper surface B_UF of the light blocking part BMA, the organic film TMA may have a first width W1 of about 0. When in a region adjacent to the upper surface B_UF of the light blocking part BMA, the organic film TMA has a first width W1 of 0, and the optical pattern LRP may be in contact with the light blocking part BMA. When in a region adjacent to the upper surface B_UF of the light blocking part BMA, the organic film TMA has a first width W1 of 0, and a portion of the first patterned portion L-P1 of the optical pattern LRP may be in contact with the light blocking part BMA. When in a region adjacent to the upper surface B_UF of the light blocking part BMA, the organic film TMA has a first width W1 of 0, and a portion of the third patterned portion L-P3 of the optical pattern LRP may be in contact with the light blocking part BMA.

The transmission part VC may be spaced apart from the organic film TMA with the optical pattern LRP disposed therebetween in one direction perpendicular to the thickness direction DR3. The transmission part VC may include a first portion V-P1 and a second portion V-P2 extending from the first portion V-P1. The first portion V-P1 of the transmission part VC may be spaced apart from the organic film TMA with the optical pattern LRP disposed therebetween in one direction perpendicular to the thickness direction DR3. A width of the first portion V-P1 of the transmission part VC may increase as the first portion V-P1 is disposed farther away from the display module DM. A width of the first portion V-P1 of the transmission part VC may be in one direction perpendicular to the thickness direction DR3.

The first portion V-P1 of the transmission part VC may be disposed to fill a remaining region other than one region in which the optical pattern LRP is disposed within the second region T-OH2. One region of the second region T-OH2 may be the same as a region in which the first patterned portion L-P1 (or the third patterned portion L-P3) of the optical pattern LRP is disposed, and the other region of the second region T-OH2 may be the same as a region in which the first portion V-P1 of the transmission part VC is disposed.

The second portion V-P2 of the transmission part VC may be disposed on the organic film TMA and the light blocking part BMA. The second portion V-P2 of the transmission part VC may overlap the organic film TMA and the light blocking part BMA. For example, the second portion V-P2 of the transmission part VC may entirely overlap the display element layer DP-ED (see FIG. 4).

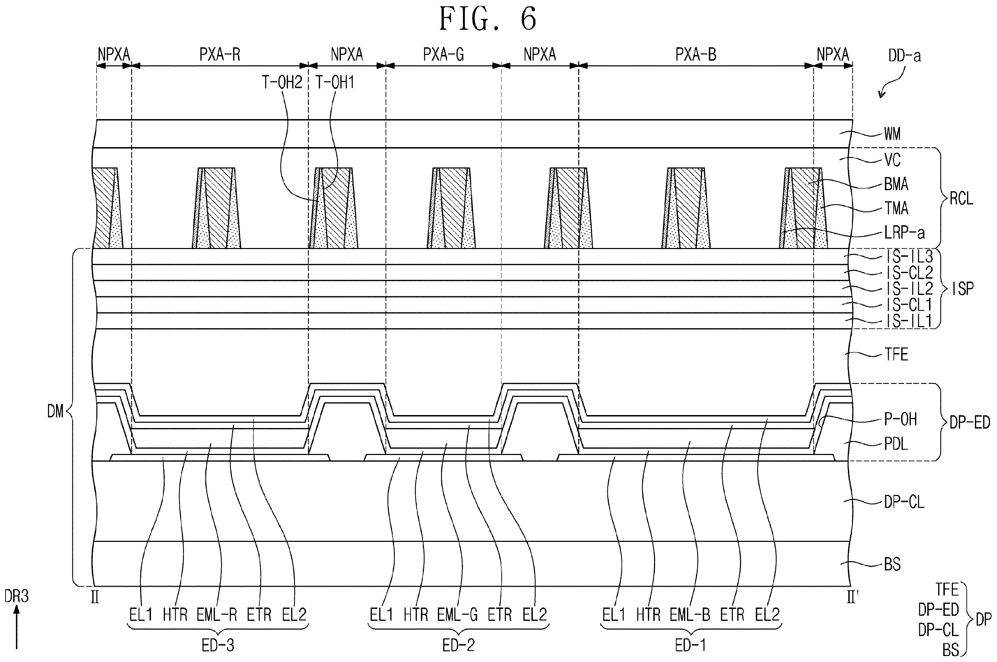

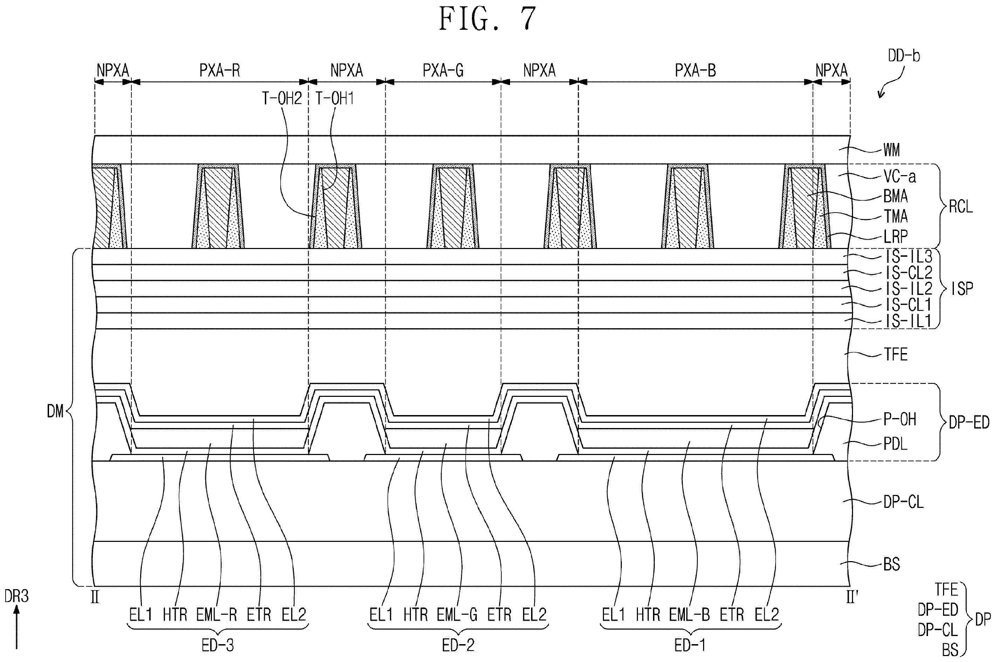

FIGS. 6 and 7 are cross-sectional views illustrating display devices according to embodiments of the inventive concept. Hereinafter, for convenience of explanation, a further description of components and technical aspects previously described with reference to FIGS. 1to 5 may be omitted with regard to the descriptions of FIGS. 6 and 7.

Compared to the display device DD illustrated in FIG. 4, a display device DD-a illustrated in FIG. 6 differs with regard to an optical pattern LRP-a from the display device DD. The optical pattern LRP-a illustrated in FIG. 6 does not include the second and third patterned portions L-P2 and L-P3 (see FIG. 5), and includes only the first patterned portion L-P1 (see FIG. 5). The optical pattern LRP-a may be disposed only on the first side surface B_SF1 (see FIG. 5) of the light blocking part BMA, and is not disposed on the upper surface B_UF (see FIG. 5) of the light blocking part BMA and the second side surface B_SF2 (see FIG. 5) of the light blocking part BMA. The optical pattern LRP-a illustrated in FIG. 6 does not overlap the light blocking part BMA. The upper surface of optical pattern LRP-a may be disposed on the substantially same plane as the upper surface of the organic film TMA.

Compared to the display device DD illustrated in FIG. 4, a display device DD-b illustrated in FIG. 7 differs with regard to a transmission part VC-a from the display device DD. The transmission part VC-a illustrated in FIG. 7 may include only the first portion V-P1 (see FIG. 5), and does not include the second portion V-P2 (see FIG. 5). The transmission part VC-a illustrated in FIG. 7 does not overlap the light blocking part BMA.

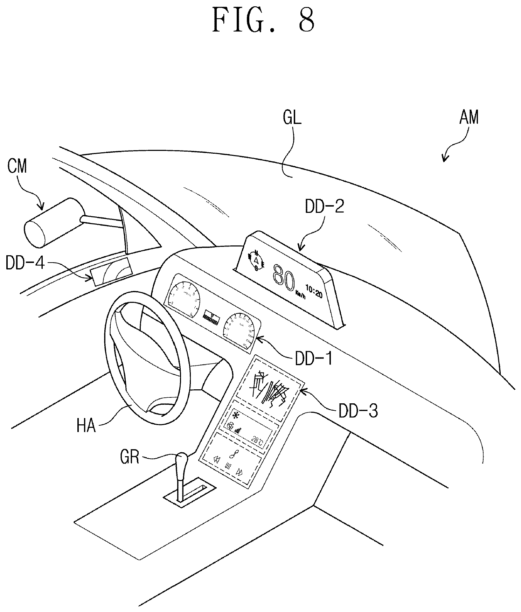

FIG. 8 is a view illustrating a vehicle AM in which first to fourth display devices DD-1, DD-2, DD-3, and DD-4 are disposed. At least one among the first to fourth display devices DD-1, DD-2, DD-3, and DD-4 may similarly include components of the display device DD, according to an embodiment, described above with reference to FIGS. 1 to 7.

FIG. 8 illustrates that the vehicle AM is a car, but this is presented as an example, and embodiments are not limited thereto. For example, according to embodiments, the first to fourth display devices DD-1, DD-2, DD-3, and DD-4 may also be disposed in other transportation means such as a bicycle, a motorcycle, a train, a ship, an airplane, etc. Additionally, at least one among the first to fourth display devices DD-1, DD-2, DD-3, and DD-4 which similarly include components of the display device DD according to an embodiment may also be employed to a personal computer, a laptop computer, a personal digital terminal, a game console, a portable electronic device, a television, a monitor, an outdoor billboard, etc. Also, these are merely presented as examples, and at least one among the first to fourth display devices DD-1, DD-2, DD-3, and DD-4 which similarly include components of the display device DD according to an embodiment may be employed to other electronic devices.

Referring to FIG. 8, the vehicle AM may include a steering wheel HA and a gear GR for operating the vehicle AM. The vehicle AM may include a windshield GL disposed toward a driver.

The first display device DD-1 may be disposed in a first region overlapping the steering wheel HA. For example, the first display device DD-1 may be a digital cluster which displays first information of the vehicle AM. The first information may include a first scale which indicates a driving speed of the vehicle AM, a second scale which indicates a rotation speed of an engine (e.g., revolutions per minute (RPM)), an image which indicates a fuel condition, and the like. The first scale and the second scale may be displayed as digital images.

The second display device DD-2 may be disposed in a second region which faces a driver's seat and overlaps the windshield GL. The driver's seat may be a seat near which the steering wheel HA is disposed. For example, the second display device DD-2 may be a head-up display (HUD) which displays second information of the vehicle AM. The second display device DD-2 may be optically transparent. The second information may include, for example, a digital number which indicates a driving speed of the vehicle AM, and further include information such as a current time. Unlike what is illustrated, the second information of the second display device DD-2 may also be projected onto the windshield GL to be displayed.

The third display device DD-3 may be disposed in a third region adjacent to the gear GR. For example, the third display device DD-3 may be a center information display (CID) for a vehicle which is disposed between a driver's seat and a passenger seat and displays third information. The passenger seat may be a seat spaced apart from the driver's seat with the gear GR disposed therebetween. The third information may include information about a road condition (for example, navigation information), music or radio playing, dynamic image playing, a temperature inside the vehicle AM, etc.

The fourth display device DD-4 may be disposed in a fourth region which is spaced apart from the steering wheel HA and the gear GR and is adjacent to a side portion of the vehicle AM. For example, the fourth display device DD-4 may be a digital side-view mirror which displays fourth information. The fourth display device DD-4 may display an exterior image, from the vehicle AM, which is captured by a camera module CM disposed outside the vehicle AM. The fourth information may include an exterior image from the vehicle AM.

The first to fourth information described above is presented as an example, and the first to fourth display devices DD-1, DD-2, DD-3, and DD-4 may further display information about an interior and an exterior of the vehicle. The first to fourth information may include different information. However, embodiments of the inventive concept are not limited thereto, and some pieces of the first to fourth information may include the same information.

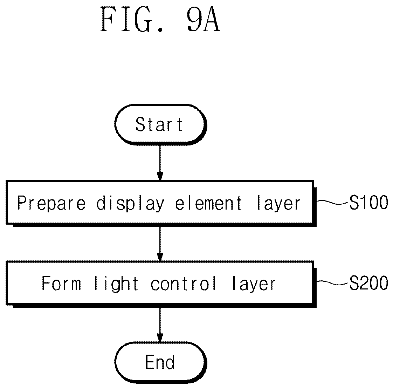

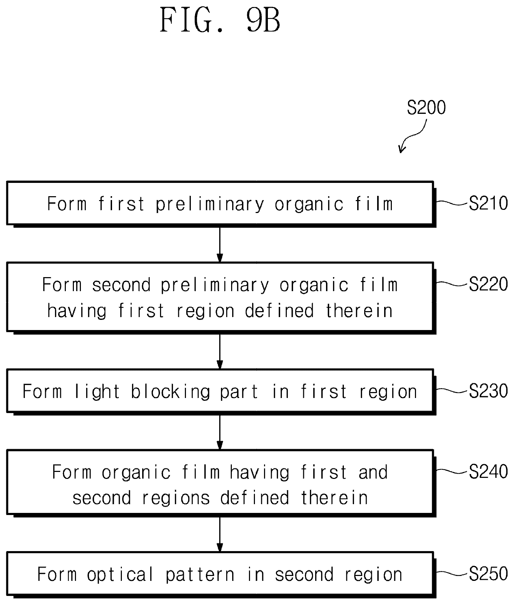

A display device according to an embodiment may be formed through a manufacturing method of a display device according to an embodiment. FIGS. 9A and 9B are flowcharts showing a manufacturing method of a display device according to an embodiment. FIGS. 10 to 14 are views schematically illustrating display device manufacturing operations according to an embodiment. Hereinafter, with regard to the descriptions of FIGS. 9A to 14, for convenience of explanation, a further description of components and technical aspects previously described with the references to FIGS. 1 to 8 may be omitted.

Referring to FIG. 9A, the method of manufacturing the display device according to an embodiment may include preparing a display element layer (S100) and forming a light control layer (S200). The light control layer RCL (see FIG. 4) may be formed on the display element layer DP-ED (see FIG. 4). Referring to FIG. 9B, the operation of forming the light control layer (S200) may include forming a first preliminary organic film (S210), forming a second preliminary organic film having a first region defined therein (S220), forming a light blocking part in the first region (S230), forming an organic film having the first region and a second region defined therein (S240), and forming an optical pattern in the second region (S250).

Referring to FIG. 10, a first preliminary organic film P1-TMA may be formed on a display module DM. The display module DM may include the display element layer DP-ED (see FIG. 4). For example, the first preliminary organic film P1-TMA may be formed by depositing an organic material. The first preliminary organic film P1-TMA may include at least one of, for example, a polyimide-based resin, an acyl-based resin, or a siloxane-based resin. However, this is presented as an example, and embodiments of the present inventive concept are not limited thereto.

Subsequently, as illustrated in FIG. 11, a second preliminary organic film P2-TMA having a first region T-OH1 defined therein may be formed by performing an etching process on the first preliminary organic film P1-TMA (see FIG. 10). The second preliminary organic film P2-TMA having the first region T-OH1 defined therein may be formed by removing a portion of the first preliminary organic film P1-TMA (see FIG. 10). The second preliminary organic film P2-TMA may be formed from the first preliminary organic film P1-TMA (see FIG. 10). For example, the first region T-OH1 may be formed through a dry etching process.

Referring to FIG. 11, a light blocking part BMA may be formed in the first region T-OH1. The light blocking part BMA which fills the first region T-OH1 may be formed by providing a light absorbing material within the first region T-OH1.

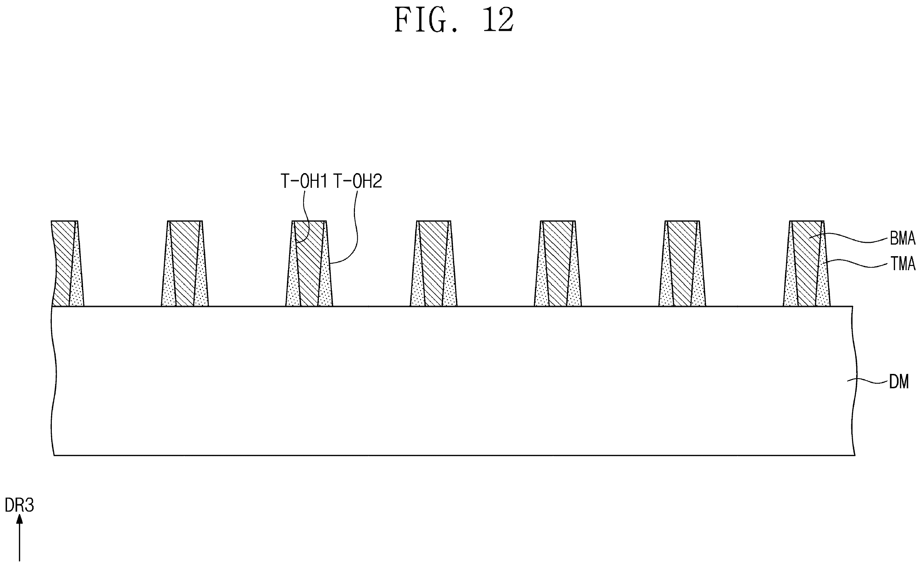

After the light blocking part BMA is formed, a second region T-OH2 may be formed as illustrated in FIG. 12. An organic film TMA having the first and second regions T-OH1 and T-OH2 defined therein may be formed by performing an etching process on the second preliminary organic film P2-TMA (see FIG. 11). The organic film TMA having the first and second regions T-OH1 and T-OH2 defined therein may be formed by removing a portion of the second preliminary organic film P2-TMA (see FIG. 11). The organic film TMA may be formed from the second preliminary organic film P2-TMA (see FIG. 11). For example, the second region T-OH2 may be formed through a dry etching process.

In the method of manufacturing the display device according to an embodiment, the operation of forming the first region T-OH1 may be performed before the operation of forming the light blocking part BMA, and the operation of forming the second region T-OH2 may be performed after the operation of forming the light blocking part BMA. The first and second regions T-OH1 and T-OH2 may be formed through a dry etching process. Accordingly, the first width W1 (see FIG. 5) of the organic film TMA may decrease as the organic film TMA is disposed farther away from the display module DM, and the second width W2 (see FIG. 5) of the light blocking part BMA may increase as the light blocking part BMA is disposed farther away from the display module DM.

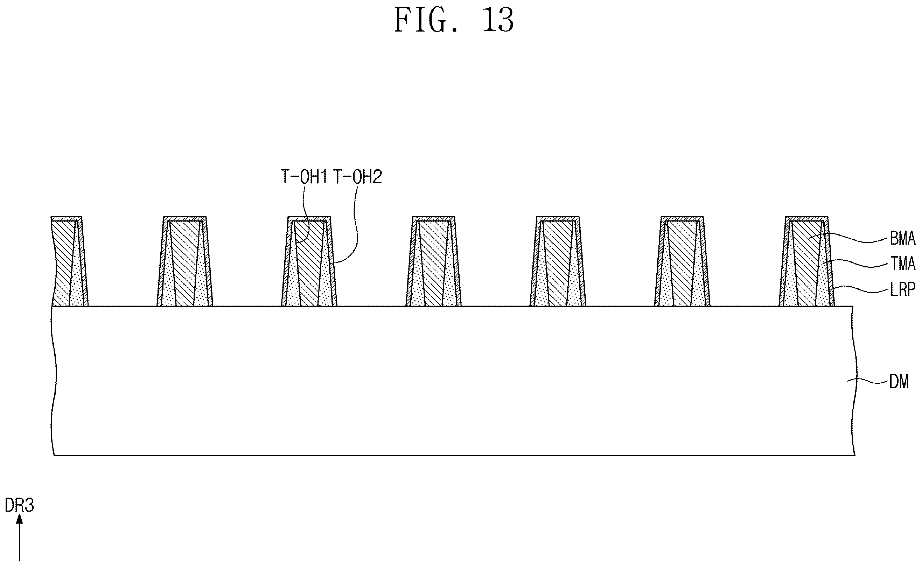

After the second region T-OH2 is formed, an optical pattern LRP may be formed as illustrated in FIG. 13. For example, the optical pattern LRP may be formed by depositing at least one of a metal or an inorganic material. When the optical pattern LRP-a illustrated in FIG. 6 is formed, the optical pattern LRP-a (see FIG. 6) including only the first patterned portion L-P1 (see FIG. 5) may be formed through a photolithography process.

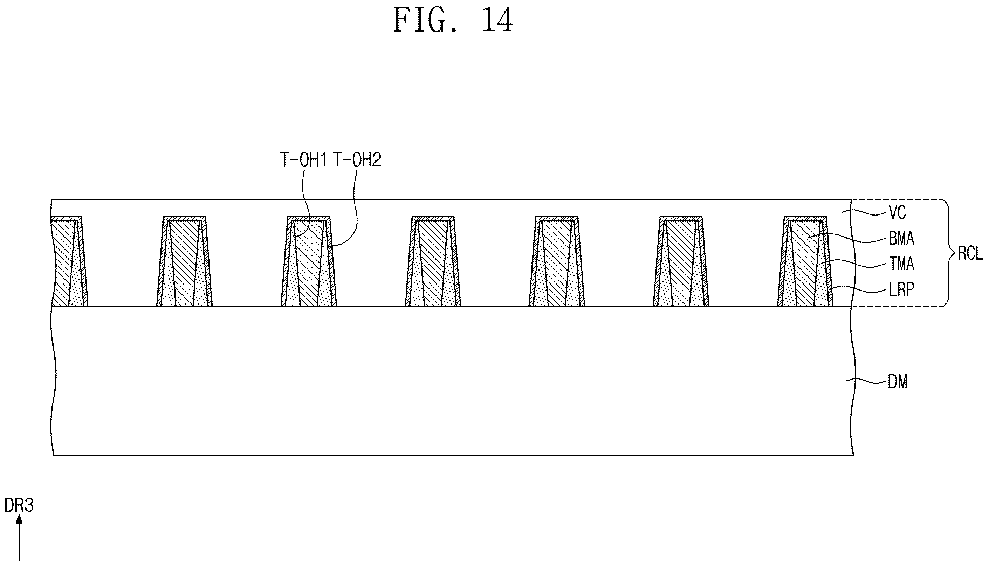

After the optical pattern LRP is formed, a transmission part VC may be formed as illustrated FIG. 14. The transmission part VC may be formed to fill a remaining region other than one region in which the optical pattern LRP is formed within the second region T-OH2. For example, the transmission part VC may be formed by coating an organic material therewith. However, this is presented as an example, and the method of forming the transmission part VC is not limited thereto.

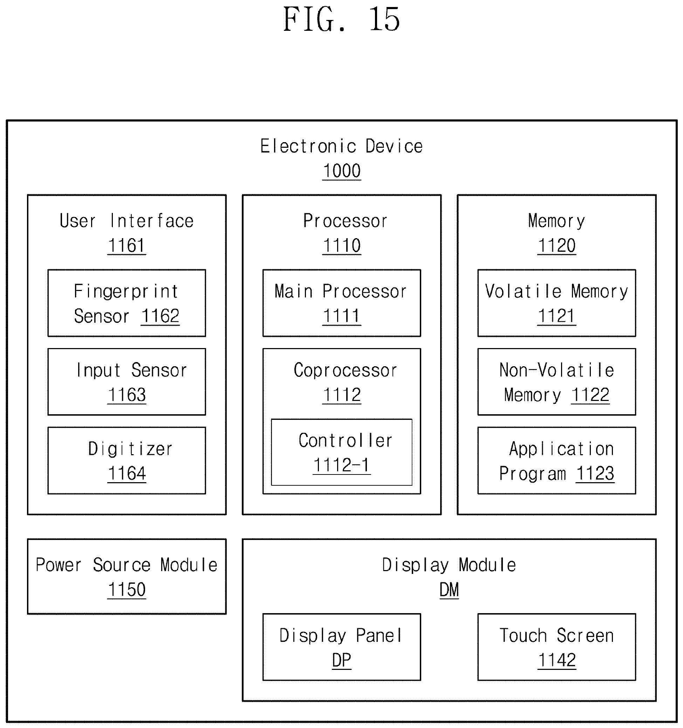

FIG. 15 is a block diagram illustrating an electronic device according to an embodiment of the inventive concept.

Referring to FIG. 15, the electronic device 1000 according to an embodiment of the inventive concept may output various information (e.g., images, text, music, etc.) through a display module DM, which, for example, may correspond to the display device DD/DD-a/DD-b described above. When a processor 1110 executes an application stored in a memory 1120, the display module DM may provide application information to a user through a display panel DP.

In some embodiments, the electronic device 1000 may be configured as, for example, a smartphone, camera, smart TV, monitor, smartwatch, tablet, automotive display, or AR/VR headset. For example, the electronic device 1000 may be a smartphone including a touch-sensitive display region for interaction and a non-display region including sensors and circuits for enhanced functionality. For example, the electronic device 1000 may be a television or monitor including a large display region for high-resolution video playback and a non-display region incorporating driving circuits or connectivity modules for external inputs. For example, the electronic device 1000 may be a smartwatch including a display region optimized for compact and high-clarity visuals and a non-display region integrating biometric sensors for health monitoring. In some cases, the electronic device 1000 be an AR/VR headset.

In some embodiments, memory 1120 may store information such as software codes for operating an application program 1123. The application program 1123 may include software designed to execute specific tasks or provide functionality to a user. The application program 1123 may operate under the control of the processor 1110 and utilizes data stored in the memory 1120 to deliver a wide range of features, such as, for example, productivity tools, multimedia streaming and playback, file or mail deliveries or communication services. The application program 1123 interacts seamlessly with the user interface 1161 or touch screen 1142, allowing a user to launch, navigate, and utilize the program through user inputs such as, for example, touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel DP, the processor 1110 activates a camera module. The processor 1110 may transmit image data corresponding to a captured image acquired through the camera module to the display module DM. The display module DM may display an image corresponding to the captured image through the display panel DP.

In an embodiment, when a user wishes to make a phone call, the user taps the telephone icon displayed on the display module DM, and the processor 1110 may execute a phone application program stored in the memory 1120. A telephone keypad may be presented on the display panel DP for the user to enter a phone number to call.

In an embodiment, the display module DM may be integrated into an electronic device 1000, such as, for example, a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module DM, and output image data. The controller 1112-1 may output various control signals to drive the display module DM. For example, the controller 1112-1 may drive the display module DM to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel DP) via the touch screen 1142 or user interface 1161 by the user. In addition, various setting data corresponding to user settings may be stored in the memory 1120. The memory 1120 may include volatile memory 1121 and non-volatile memory 1122.

The display module DM may output visual information (images) to the user. The display module DM may include the display panel DP, a gate driver, the source driver, a voltage generation circuit, and a touch screen 1142. The display module DM may further include a window, a chassis, and a bracket to protect the display panel DP. The display module DM may include at least a part of the configuration of the display device DD/DD-a/DD-b described above.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as, for example, blood pressure, moisture, or body mass.

The input sensor 1163 may sense user interactions including, for example, touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel DP.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer 1164 may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel DP through a continuous process with a process of forming elements (for example, the light-emitting element, the transistor, and the like) included in the display panel DP.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera sensor may be particularly suitable for AR/VR headset functions.

The touch screen 1142 includes touch sensors embedded in semiconductor layers of the display panel DP to sense pressure applied to the top layer (screen) of the display panel DP. The touch sensors can be a capacitive or a resistive type. The touch screen 1142 may serve as the primary interface for the user to select and navigate applications, control, and interact with the electronic device 1000.

The display panel DP (or display) may include, for example, a liquid crystal display panel, an organic light emitting display panel, or an inorganic light emitting display panel. However, the type of the display panel DP is not particularly limited. The display panel DP may be of a rigid type or a flexible type that can be rolled or folded. The display module DM may further include a supporter, bracket, heat dissipation member, and the like that support the display panel DP. The display panel DP may include the display device DD/DD-a/DD-b described above.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power to each of the components described above including the display module DM.

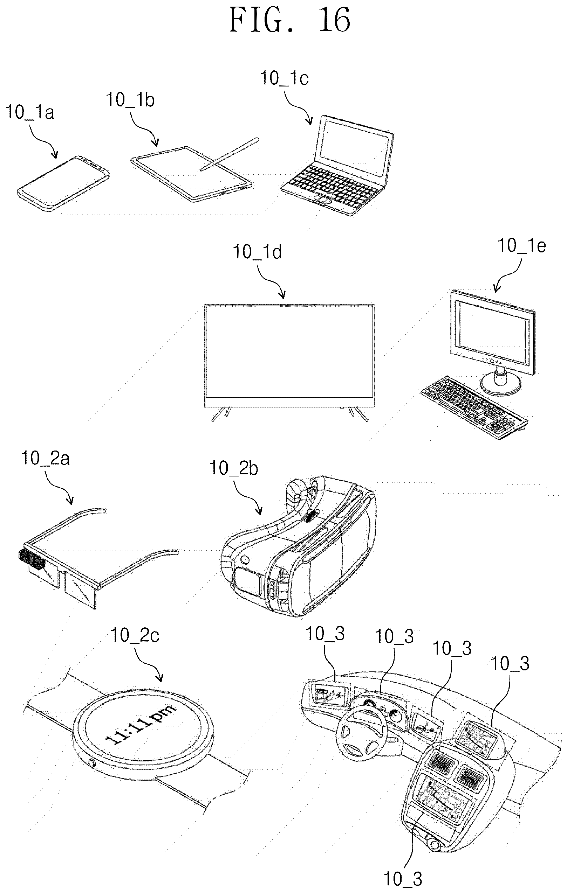

FIG. 16 is a schematic view illustrating electronic devices according to various embodiments. Referring to FIG. 16, an electronic device including the display device DD/DD-a/DD-b according to an embodiment may include not only electronic device for displaying images, e.g., a smartphone 10_1a, a tablet computer (PC) 10_1b, a laptop computer 10_1c, TV 10_1d, and a monitor for a desk computer 10_1e, but also wearable electronic devices including display devices, e.g., smart glasses 10_2a, a head mounted display 10_2b, and a smart watch 10_2c, and vehicle electronic device 10_3 including display devices, e.g., a vehicle instrument panel, a center fascia, a center information display (CID) disposed on a dashboard, and a room mirror display.

A method of manufacturing a display device according to an embodiment may include an operation of forming a light control layer on a display element layer. The method may include operations of forming first and second regions before and after an operation of forming a light blocking part. A transmission part in which the first and second regions spaced apart from each other in one direction perpendicular to a thickness direction are defined may be formed by performing an etching process on a preliminary organic film. The light blocking part is formed to fill the first region, and then an optical pattern may be formed within the second region.

A display device according to an embodiment manufactured through the manufacturing method of the display device according to an embodiment may include a light control layer disposed on a display element layer. The light control layer may include an organic film having first and second regions defined therein, a light blocking part disposed to fill the first region, and an optical pattern disposed within the second region. A first width of the organic film may decrease as the organic film is disposed farther away from the display element layer, and a second width of the light blocking part may increase as the light blocking part is disposed farther away from the display element layer. The optical pattern may be disposed on an inner side surface, of the organic film, defining the second region. In a cross-section, the organic film, the light blocking part, and the optical pattern may form a trapezoid-shaped structure, and thus, the light control layer according to an embodiment may include the trapezoid-shaped structure, which may exhibit excellent light blocking properties. Therefore, in an embodiment, the display device including the light control layer may exhibit excellent display quality.

A display device according to an embodiment may include an optical pattern disposed within a second region, thereby exhibiting excellent display quality.

A method of manufacturing the display device according to an embodiment includes an operation of forming an optical pattern within the second region, thereby making it possible to provide a display device with excellent display quality.

While the inventive concept has been particularly shown and described with reference to embodiments thereof, it will be understood by those of ordinary skill in the art that various changes in form and detail may be made therein without departing from the scope of the inventive concept as defined by the following claims.

## Claims

1. A display device (DD), comprising:
a display element layer (DP-ED) including a pixel-defining film (PDL) and a light-emitting element (ED-1, ED-2, ED-3); and
a light control layer (RCL) disposed on the display element layer (DP-ED) in a thickness direction (DR3) of the display device (DD),
wherein the light control layer (RCL) includes an organic film (TMA) in which a first region (T-OH1) and a second region (T-OH2) at least partially spaced apart from each other in one direction perpendicular to the thickness direction (DR3) are defined, a light blocking part (BMA) disposed in the first region (T-OH1), and an optical pattern (LRP) disposed in the second region (T-OH2),
wherein a first width (W1) of the organic film (TMA) between the light blocking part (BMA) and the optical pattern (LRP) in the one direction progressively decreases away from the display element layer (DP-ED) along the thickness direction (DR3),
a second width (W2) of the light blocking part (BMA) in the one direction progressively increases away from the display element layer (DP-ED) along the thickness direction (DR3).

2. The display device (DD) of claim 1, wherein the optical pattern (LRP) comprises:
a first patterned portion (L-P1) disposed in the second region (T-OH2) and inclined with respect to the thickness direction (DR3); and
a second patterned portion (L-P2) extending in the one direction from the first patterned portion (L-P1).

3. The display device (DD) of claim 2, wherein the second region (T-OH2) comprises a first sub-region (T-OH21) and a second sub-region (T-OH22), and is provided in a plurality,
the first patterned portion (L-P1) is disposed in the first sub-region (T-OH21), and
the optical pattern (LRP) further comprises a third patterned portion extending from the second patterned portion (L-P2) and disposed in the second sub-region (T-OH22).

4. The display device (DD) of at least one of claims 1 to 3, wherein the optical pattern (LRP) comprises at least one of a metal or an inorganic material.

5. The display device (DD) of at least one of claims 1 to 4, wherein the optical pattern (LRP) has a reflectance of about 10% or less.

6. The display device (DD) of at least one of claims 1 to 5, wherein in a cross-section parallel to the thickness direction (DR3), the organic film (TMA), the light blocking part (BMA), and the optical pattern (LRP) form a trapezoidal shape.

7. The display device (DD) of at least one of claims 1 to 6, further comprising:
a transmission part (VC) filling a remaining region other than one region in which the optical pattern (LRP) is disposed in the second region (T-OH2).

8. The display device (DD) of claim 7, wherein the optical pattern (LRP) is disposed between the transmission part (VC) and the organic film (TMA), in the one direction.

9. The display device (DD) of claim 7 or 8, wherein the transmission part (VC) comprises:
a first portion (V-P1) disposed in the second region (T-OH2); and
a second portion (V-P2) extending from the first portion (V-P1) and overlapping the light blocking part (BMA).

10. The display device (DD) of at least one of claims 1 to 9, wherein an angle (θ_{T}) formed between a plane (VP) perpendicular to the thickness direction (DR3) and an inner side surface (T_SF) of the organic film (TMA) defining the second region (T-OH2) is about 87° to about 89°.

11. The display device (DD) of at least one of claims 1 to 10, wherein the light blocking part (BMA) is provided as a plurality of light blocking parts (BMA) which are spaced apart from each other in the one direction, and
the light blocking parts (BMA) each overlap at least one of the pixel-defining film (PDL) or the light-emitting element (ED-1, ED-2, ED-3).

12. The display device (DD) of at least one of claims 1 to 11, wherein the pixel-defining film (PDL) has a pixel opening (P-OH) defined therein, and
the light-emitting element (ED-1, ED-2, ED-3) comprises a first electrode (EL1) exposed in the pixel opening (P-OH), a second electrode (EL2) disposed on the first electrode (EL1), and a light-emitting layer (EML-B, EML-G, EML-R) disposed between the first electrode (EL1) and the second electrode (EL2).

13. An electronic device (1000), comprising:
a processor (1110);
a memory (1120) having stored application programs for execution by the processor (1110);
a display device (DD) according to at least one of claims 1 to 12; and
a user interface (1161) configured to sense user input via touch or cursor select of an icon presented on the display panel, wherein the processor (1110) is caused to execute one or more of the stored application programs upon receipt of the user input.

14. A method of manufacturing a display device (DD) according to at least one of claims 1 to 12, the method including:
preparing the display element layer (DP-ED),
forming, on the display element layer (DP-ED) in the thickness direction (DR3), the light control layer (RCL) by forming a first preliminary organic film (P1-TMA) on the display element layer (DP-ED), forming a second preliminary organic film (P2-TMA) having the first region (T-OH1) defined therein by removing a portion of the first preliminary organic film (P1-TMA), forming the light blocking part (BMA) in the first region (T-OH1), forming the organic film (TMA) having the first region (T-OH1) and the second region (T-OH2) defined therein by removing a portion of the second preliminary organic film (P2-TMA), and forming the optical pattern (LRP) in the second region (T-OH2).
